# EUROPEAN PATENT APPLICATION

(11) **EP 4 474 363 A1**
(43) Date of publication of application: **11.12.2024**
(21) Application number: 23781145.0
(22) Date of filing: 31.01.2023
(51) Int. Cl.: C03C 17/00, C03C 17/34, G02B 1/14, G02B 1/10

(54) **DISPLAY DEVICE AND ELECTRONIC DEVICE COMPRISING SAME**

(30) Priority: 29.03.2022 KR 20220039105; 27.05.2022 KR 20220065339
(71) Applicant: Samsung Electronics Co., Ltd., Gyeonggi-do, 16677 (KR)
(72) Inventor: BAE, Jaehyun, Suwon-si Gyeonggi-do 16677 (KR); MOON, Youngmin, Suwon-si Gyeonggi-do 16677 (KR); LEE, Changsu, Suwon-si Gyeonggi-do 16677 (KR)
(74) Representative: Gulde & Partner
(86) International application number: PCT/KR2023/001404
(87) International publication number: WO 2023/191285

(57) **Abstract**

A display device is provided. The display device includes a display panel, and a window which is disposed on the display panel and in which a bending region that can be bent and a flat region that is kept flat are defined, wherein the window includes a base layer, and a first hard coating layer which is disposed on one surface of the base layer and includes a plurality of coating portions each having a different hardness, and wherein the thickness of the first hard coating layer disposed on the flat region may be thicker than that of the first hard coating layer disposed on the bending region.

## Description

### [Technical Field]

Various embodiments of the disclosure relate to a display device configured as a flexible display and an electronic device including the same.

### [Background Art]

Recently, there is increasing interest in bendable electronic devices (hereinafter, `flexible electronic devices') including a bendable flexible display (hereinafter, `flexible display device'). The window member used in the flexible display device requires flexibility for preventing deformation when folded or bent as well as impact resistance from surface hardness or strength.

### [Detailed Description of the Invention]

### [Technical Solution]

Various embodiments of the disclosure may configure a window of a display device by applying coating portions with different hardnesses to secure flexibility while enhancing the impact resistance of a bending portion vulnerable to external impact in a flexible display device.

A display device according to an embodiment of the disclosure may comprise a display panel and a window disposed on the display panel and in which a bending area and a flat area remaining flat are defined. The window may include a base layer, and a first hard coating layer disposed on one surface of the base layer and including a plurality of coating portions having different hardnesses. A thickness of the first hard coating layer disposed on the flat area may be larger than a thickness of the first hard coating layer disposed on the bending area.

An electronic device according to an embodiment of the disclosure may comprise a bendable housing configured to facilitate bending along a bending axis, and a flexible display including a display panel, a window disposed on the display panel, and a protective layer disposed on the window, defining a bending area and a flat area remaining flat, and accommodated in the housing. The window may include a base layer, and a first hard coating layer disposed on one surface of the base layer and including a plurality of coating portions having different hardnesses. A thickness of the first hard coating layer disposed on the flat area may be larger than a thickness of the first hard coating layer disposed on the bending area.

According to various embodiments proposed in the disclosure, in a display device, it is possible to enhance the bending performance of the bent portion by differentially forming the thickness of the hard coating layer of the window.

According to various embodiments proposed in the disclosure, in a display device, it is possible to enhance impact resistance by stacking coating portions having different hardnesses on a hard coating layer of a window.

Effects achievable in example embodiments of the disclosure are not limited to the above-mentioned effects, but other effects not mentioned may be apparently derived and understood by one of ordinary skill in the art to which example embodiments of the disclosure pertain, from the following description. In other words, unintended effects in practicing embodiments of the disclosure may also be derived by one of ordinary skill in the art from example embodiments of the disclosure.

### [Brief Description of Drawings]

FIG. 1 is a view illustrating an electronic device in a network environment according to various embodiments;
FIG. 2 is a view illustrating an unfolded state of an electronic device according to various embodiments of the disclosure;
FIG. 3 is a view illustrating a folded state of an electronic device according to various embodiments of the disclosure;
FIG. 4 is a perspective view illustrating an example of an electronic device in a fully unfolded state or a partially unfolded intermediate state, according to various embodiments of the disclosure;
FIG. 5 is a cross-sectional view illustrating an electronic device according to various embodiments of the disclosure;
FIG. 6 is a plan view illustrating the window of FIG. 5;
FIG. 7 is a cross-sectional view taken along line VII-VII' of FIG. 6;
FIG. 8 is a cross-sectional view taken along line VIII-VIII' of FIG. 6;
FIGS. 9 and 10 are views illustrating a window according to another embodiment of the disclosure;
FIGS. 11 to 19 are views illustrating a window having a vertical stacked structure according to various embodiments of the disclosure;
FIG. 20 is a view illustrating a first of a window having a vertical stacked structure according to various embodiments of the disclosure;
FIGS. 21 to 23 are views illustrating a window having an embedded structure according to various embodiments of the disclosure;
FIGS. 24 to 28 are views illustrating a window structure applied to a rollable display device according to various embodiments of the disclosure;
FIG. 29 is a flowchart illustrating a method for manufacturing a horizontal stacked structure of a window according to various embodiments of the disclosure;
FIGS. 30A to 30C are views illustrating an example of a method for manufacturing a horizontal stacked structure of a window according to various embodiments of the disclosure;
FIG. 31 is a view illustrating an example of a method for manufacturing a vertical stacked structure of a window according to various embodiments of the disclosure;
FIGS. 32A to 32C are views illustrating an example of a method for manufacturing a vertical stacked structure of a window according to various embodiments of the disclosure; and
FIG. 33 is a flowchart illustrating a process of applying a coating portion of a base layer of a window according to various embodiments of the disclosure.

Reference may be made to the accompanying drawings in the following description, and specific examples that may be practiced are shown as examples within the drawings. Other examples may be utilized and structural changes may be made without departing from the scope of the various examples.

### [Mode for Carrying out the Invention]

Embodiments of the present invention are now described with reference to the accompanying drawings in such a detailed manner as to be easily practiced by one of ordinary skill in the art. However, the disclosure may be implemented in other various forms and is not limited to the embodiments set forth herein. The same or similar reference denotations may be used to refer to the same or similar elements throughout the specification and the drawings. Further, for clarity and brevity, no description is made of well-known functions and configurations in the drawings and relevant descriptions.

Hereinafter, embodiments of the present disclosure are described with reference to the accompanying drawings.

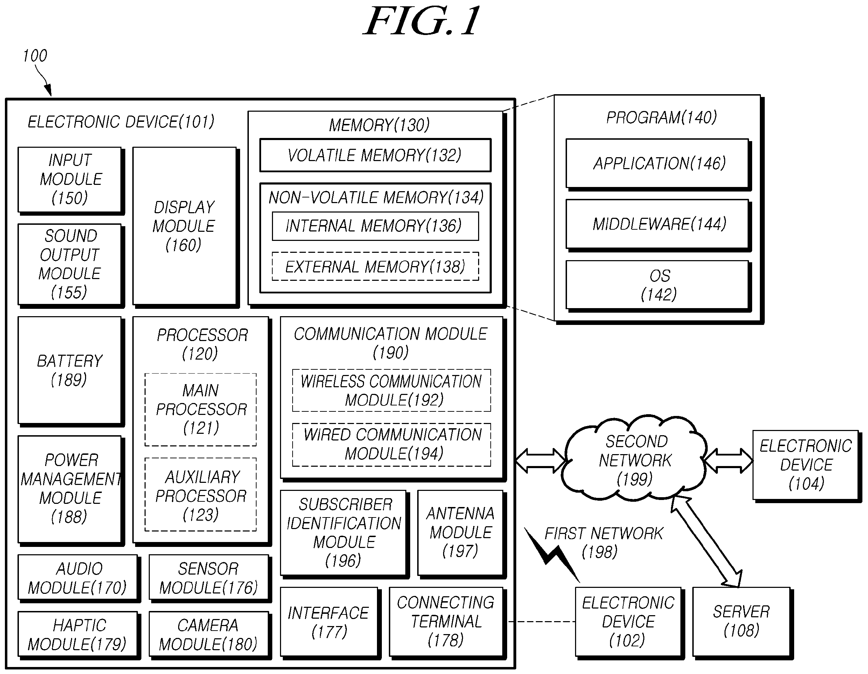

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

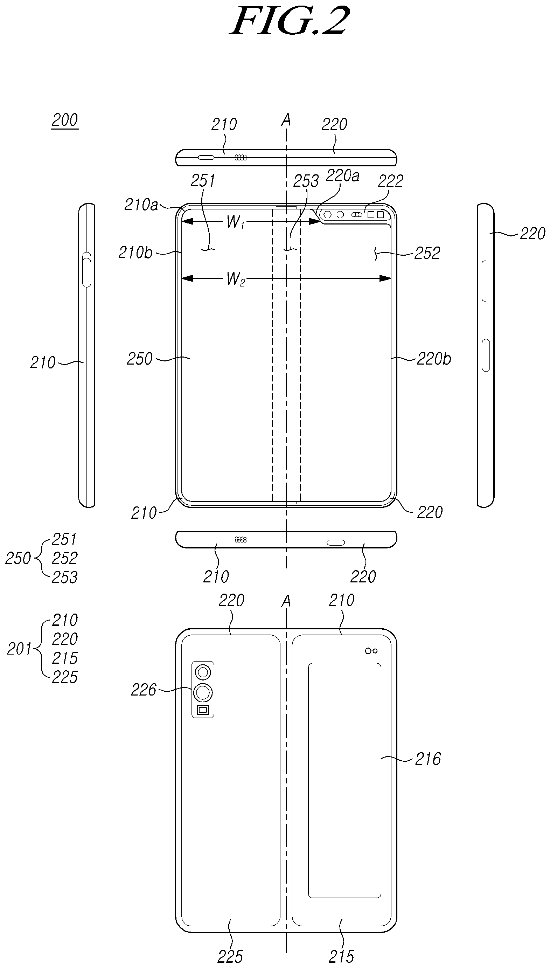

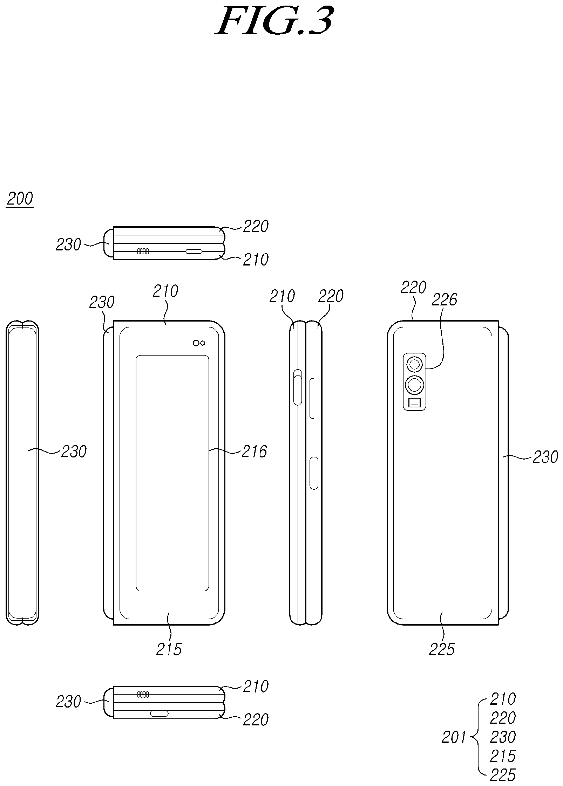

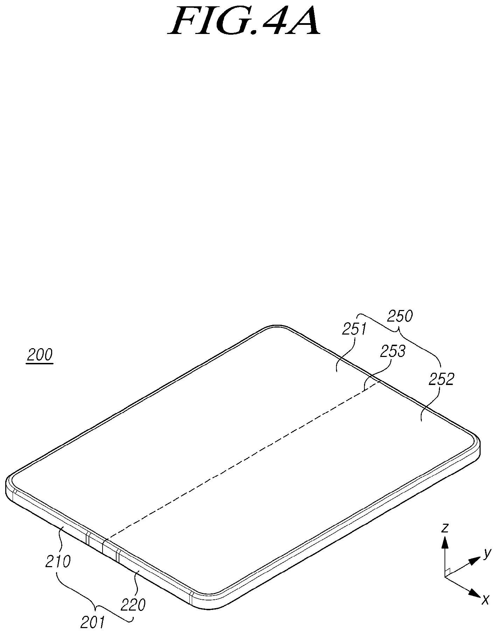

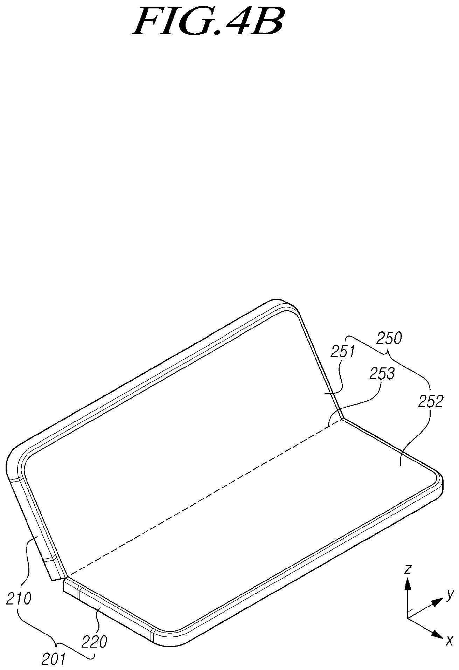

FIG. 2 is a view illustrating an unfolded state of an electronic device 200 according to various embodiments of the disclosure. FIG. 3 is a view illustrating a folded state of an electronic device 200 according to various embodiments of the disclosure. FIG. 4 is a perspective view illustrating an example of an electronic device 200 in a fully unfolded state or a partially unfolded intermediate state, according to various embodiments of the disclosure.

The electronic device 200 of FIGS. 2 and 4, as an example of the electronic device 101 shown in FIG. 1, may be a foldable or bendable electronic device.

FIG. 4 and the subsequent figures illustrate a spatial coordinate system defined by an X-axis, a Y-axis and a Z-axis orthogonal to each other. Here, the X axis may indicate a width direction of the electronic device, the Y axis may indicate a length direction of the electronic device, and the Z axis may indicate a height (or thickness) direction of the electronic device. In the following description, "first direction" may mean a direction parallel to the Z axis.

Referring to FIGS. 2 and 3, according to an embodiment, the electronic device 200 may include a foldable housing 201 (or bendable housing) and a flexible or foldable display 250 (hereinafter, simply " flexible display 250") (e.g., the display device 160 of FIG. 1) disposed in a space formed by the foldable housing 201. According to an embodiment, the surface where the flexible display 250 is disposed (or the surface where the display 250 is viewed from the outside of the electronic device 200) may be defined as the front surface of the electronic device 200. The opposite surface of the front surface may be defined as a rear surface of the electronic device 200. The surface surrounding the space between the front and back surfaces may be defined as a side surface of the electronic device 200.

According to various embodiments, the foldable housing 201 may include a first housing structure 210, a second housing structure 220 including a sensor area 222, a first rear cover 215, a second rear cover 225, and a hinge structure 230. Here, the hinge structure 230 may include a hinge cover covering a foldable portion of the foldable housing 201. The foldable housing 201 of the electronic device 200 are not limited to the shape and coupling shown in FIGS. 2 and 3 but may rather be implemented in other shapes or via a combination and/or coupling of other components. For example, the first housing structure 210 and the first rear cover 215 may be integrally formed with each other, and the second housing structure 220 and the second rear cover 225 may be integrally formed with each other.

According to various embodiments, the first housing structure 210 may be connected to the hinge structure 230 and may include a first surface facing in a first direction and a second surface facing in a second direction opposite to the first direction. The second housing structure 220 may be connected to the hinge structure 230 and may include a third surface facing in a third direction and a fourth surface facing in a fourth direction opposite to the third direction. The second housing structure 220 may rotate about the hinge structure 230 from the first housing structure 210. The electronic device 200 may transform to a folded status or an unfolded status.

According to an embodiment, the first surface of the electronic device 200 may face the third surface in a fully folded state. In the fully unfolded state, the third direction may be the same as the first direction.

According to various embodiments, the first housing structure 210 and the second housing structure 220 may be positioned on opposite sides of a folding axis (bending axis A), and they may be overall symmetrical in shape with each other with respect to the folding axis A. As described below, the angle or distance between the first housing structure 210 and the second housing structure 220 may be varied depending on whether the electronic device 200 is in the unfolded state, the folded state, or the partially unfolded (or partially folded) intermediate state. According to an embodiment, the second housing structure 220 further includes the sensor area 222 where various sensors are disposed, unlike the first housing structure 210 but, in the remaining area, the second housing structure 320 may be symmetrical in shape with the first housing structure 310. In another embodiment, the sensor area 222 may additionally be disposed in, or replaced by, at least a partial area of the second housing structure 220. For example, the sensor area 222 may include a camera hall area, a sensor hall area, an under display camera (UDC) area, and an under display sensor (UDS) area.

According to various embodiments, as shown in FIG. 2, the first housing structure 210 and the second housing structure 220 together may form a recess to receive the display 250. In an embodiment, due to the sensor area 222, the recess may have two or more different widths in the direction perpendicular to the folding axis A. According to an embodiment, the recess may have a first width w1 between a first portion 210a of the first housing structure 210, which is parallel with the folding axis A, and a first portion 220a of the second housing structure 220, which is formed at an edge of the sensor area 222. The recess may have a second width w2 formed by a second portion 220b of the first housing structure 210 and a second portion 220b of the second housing structure 220, which does not correspond to the sensor area 222 and is parallel with the folding axis A. In this case, the second width w2 may be longer than the first width w1. In an embodiment, the first portion 220a and second portion 220b of the second housing structure 220 may have different distances from the folding axis A. The width of the recess is not limited thereto. According to another embodiment, the recess may have a plurality of widths due to the shape of the sensor area 222 or the asymmetric portions of the first housing structure 210 and the second housing structure 220. According to various embodiments, the sensor area 222 may be formed adjacent to a corner of the second housing 220 and to have a predetermined area. However, the placement, shape, or size of the sensor area 222 is not limited to those illustrated. For example, in another embodiment, the sensor area 222 may be disposed in a different corner of the second housing structure 220 or in any area between the top corner and the bottom corner. In an embodiment, components for performing various functions, embedded in the electronic device 200, may be exposed through the sensor area 222 or one or more openings in the sensor area 222 to the front surface of the electronic device 200. In various embodiments, the components may include various kinds of sensors. The sensor may include, e.g., at least one of a front camera, a receiver, or a proximity sensor. According to various embodiments, in the second housing structure 220, the sensor area 222 may be omitted or may be formed in a position different from that shown in the drawings.

According to various embodiments, at least a portion of the first housing structure 210 and the second housing structure 220 may be formed of a metal or a non-metal material having a predetermined degree of rigidity to support the display 250. At least a portion formed of metal may provide a ground plane of the electronic device 200 and may be electrically connected with a ground line formed on the printed circuit board disposed in the foldable housing 201.

According to various embodiments, the first rear cover 215 may be disposed on one side of the folding axis A on the rear surface of the electronic device 200 and have, e.g., a substantially rectangular periphery which may be surrounded by the first housing structure 210. Similarly, the second rear cover 225 may be disposed on the opposite side of the folding axis A on the rear surface of the electronic device 200 and its periphery may be surrounded by the second housing structure 220.

According to various embodiments, the first rear cover 215 and the second rear cover 225 may be substantially symmetrical in shape with respect to the folding axis A. However, the first rear cover 215 and the second rear cover 225 are not necessarily symmetrical in shape. In another embodiment, the electronic device 200 may include the first rear cover 215 and the second rear cover 225 in various shapes. According to another embodiment, the first rear cover 215 may be integrally formed with the first housing structure 210, and the second rear cover 225 may be integrally formed with the second housing structure 220.

According to various embodiments, the first rear cover 215, the second rear cover 225, the first housing structure 210, and the second housing structure 220 may form a space where various components (e.g., a printed circuit board or battery) of the electronic device 200 may be disposed. According to an embodiment, one or more components may be disposed or visually exposed on the rear surface of the electronic device 200. For example, at least a portion of a sub display may be visually exposed through a first rear surface area 216 of the first rear cover 215. In another embodiment, one or more components or sensors may be visually exposed through a second rear surface area 226 of the second rear cover 225. According to various embodiments, the sensor may include a proximity sensor and/or a rear-facing camera.

According to various embodiments, a front camera exposed to the front surface of the electronic device 200 through one or more openings prepared in the sensor area 222 or a rear camera exposed through a second rear surface area 226 of the second rear cover 225 may include one or more lenses, an image sensor, and/or an image signal processor. The flash may include, e.g., a light emitting diode (LED) or a xenon lamp. In an embodiment, two or more lenses (infrared camera, wide-angle and telephoto lens) and image sensors may be disposed on one surface of the electronic device 200.

Referring to FIG. 3, the hinge cover may be disposed between the first housing structure 210 and the second housing structure 220 to hide the internal components (e.g., the hinge structure 230). According to an embodiment, the hinge structure 230 may be hidden by a portion of the first housing structure 310 and second housing structure 320 or be exposed to the outside depending on the state (e.g., the unfolded state, intermediate state, or folded state) of the electronic device 200.

According to an embodiment of the present invention, as shown in FIG. 2, in the unfolded state (e.g., a fully unfolded state) of the electronic device 200, the hinge structure 230 may be hidden not to be exposed by the first housing structure 210 and the second housing structure 220. As another example, as shown in FIG. 3, in the folded state (e.g., a fully folded state) of the electronic device 200, the hinge structure 230 may be exposed to the outside between the first housing structure 210 and the second housing structure 220. As another example, in an intermediate state in which the first housing structure 210 and the second housing structure 220 are folded with a certain angle, the hinge structure 230 may be partially exposed to the outside between the first housing structure 210 and the second housing structure 220. However, in this case, the exposed area may be smaller than that in the completely folded state. According to an embodiment, the hinge structure 230 may include a curved surface.

According to various embodiments, the display 250 may be disposed in a space formed by the foldable housing 201. For example, the display 250 may be seated in a recess formed by the foldable housing 201 and may be seen from the outside through the front surface of the electronic device 200. For example, the display 250 may constitute most of the front surface of the electronic device 200. Thus, the front surface of the electronic device 200 may include the display 250 and a partial area of the first housing structure 210 and a partial area of the second housing structure 220, which are adjacent to the display 250. The rear surface of the electronic device 200 may include the first rear cover 215, a partial area of the first housing structure 210, which is adjacent to the first rear cover 215, the second rear cover 225, and a partial area of the second housing structure 220, which is adjacent to the second rear cover 225.

According to various embodiments, the display 250 may mean a display at least a portion of which may be transformed into a flat or curved surface. According to an embodiment, the display 250 may include a folding area 253, a first area 251 disposed on one side of the folding area 253 (e.g., the left side of the folding area 253 of FIG. 2), and a second area 252 disposed on the opposite side of the folding area 253 (e.g., the right side of the folding area 203 of FIG. 2).

However, the segmentation of the display 250 as shown in FIG. 2 is merely an example, and the display 250 may be divided into a plurality of (e.g., four or more, or two) areas depending on the structure or function of the display 200. For example, in the embodiment illustrated in FIG. 2, the area of the display 250 may be divided by the folding area 253 extending parallel to the folding axis A, but in another embodiment, the area of the display 250 may be divided by another folding axis (e.g., a folding axis parallel to the width direction of the electronic device).

According to various embodiments of the disclosure, the display 250 may be coupled with or disposed adjacent to a touch panel equipped with a touch detection circuit or a pressure sensor capable of measuring the strength (pressure) of a touch. For example, the display 250 may be disposed adjacent to or coupled with a touch panel, as an example of the touch pane, which detects a stylus pen of an electromagnetic resonance (EMR) type.

According to various embodiments, the first area 251 and the second area 252 may be overall symmetrical in shape with respect to the folding area 253. However, unlike the first area 251, the second area 252 may include a notch depending on the presence of the sensor area 222, but the rest may be symmetrical in shape with the first area 251. In other words, the first area 251 and the second area 252 may include symmetrical portions and asymmetrical portions.

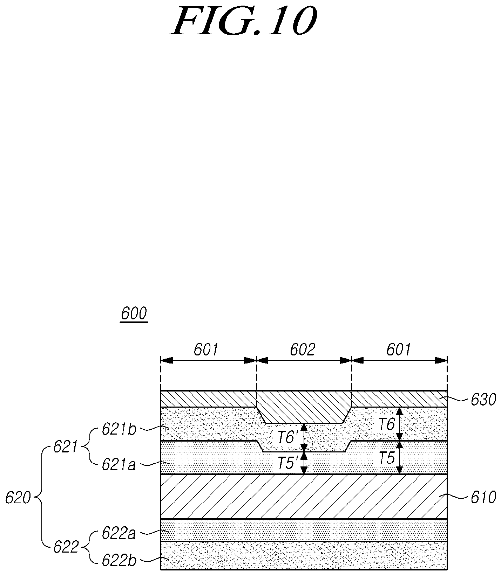

According to various embodiments, the first area 251 and the second area 252 may be formed to have different edge thicknesses from the edge thickness of the folding area 253. The edge thickness of the folding area 253 may be formed to be thinner than the thicknesses of the first area 251 and the second area 252. In terms of thickness, the first area 251 and the second area 252 may have an asymmetric shape when viewed in cross section. For example, the edge of the first area 251 may be formed to have a first radius of curvature, and the edge of the second area 252 may be formed to have a second radius of curvature that is different from the first radius of curvature. In another embodiment, in terms of thickness, the first area 251 and the second area 252 may have a symmetrical shape when the first area 251 and the second area 252 are viewed in cross section. This is described below in detail through the embodiment disclosed in FIGS. 10A and the subsequent figures.

Described below are the operation of the first housing structure 210 and the second housing structure 220 and each area of the display 250 depending on the state (e.g., the folded state, unfolded state, or intermediate state) of the electronic device 200.

According to various embodiments, when the electronic device 200 is in the unfolded state (e.g., FIG. 2), the first housing structure 210 and the second housing structure 220 may be disposed to face in the same direction while being angled at 180 degrees therebetween. The surface of the first area 251 and the surface of the second area 252 of the display 250 may be angled at 180 degrees therebetween while facing in the same direction (e.g., forward of the front surface of the electronic device). The folding area 253 may be coplanar with the first area 251 and the second area 252. As another embodiment, when the electronic device 200 is an unfolded state (flat state), the first housing structure 210 and the second housing structure 220 may be rotated at a predetermined angle (e.g., 360 degrees) with respect to each other to be folded in opposite directions so that the first rear cover 215 and the second rear cover 225 face each other, allowing the first area 251 and the second area 252 of the display to face in opposite directions to each other.

According to various embodiments, when the electronic device 200 is in the folded state (e.g., FIG. 3), the first housing structure 210 and the second housing structure 220 may face each other. The surface of the first area 251 and the surface of the second area 252 of the display 250 may be angled at a small angle (e.g., ranging from 0 degrees to 10 degrees) therebetween while facing each other. At least a portion of the folding area 253 may be formed as a curve having a predetermined curvature.

According to various embodiments, in the intermediate state of the electronic device 200, the first housing structure 210 and the second housing structure 220 may be arranged at a certain angle therebetween. The surface of the first area 251 of the display 250 and the surface of the second area 252 may form an angle which is larger than the angle in the folded state and smaller than the angle in the unfolded state. The folding area 253 may at least partially have a curved surface with a predetermined curvature and, in this case, the curvature may be smaller than that when it is in the folded state.

(a) of FIG. 4 may illustrate a fully unfolded state of the electronic device 200, and (b) of FIG. 4 may illustrate an intermediate state in which the electronic device 200 is partially unfolded. As described above, the electronic device 200 may transform into a folded status or an unfolded status. According to an embodiment, the electronic device 200 may be folded in two types, e.g., `in-folding' in which it is folded so that the front surface of the electronic device 200 forms an acute angle and 'out-folding' in which it is folded so that the front surface of the electronic device 200 forms an obtuse angle, as viewed in the direction of the folding axis (e.g., axis A of FIG. 2). For example, in the in the in-folding folded state of the electronic device 200, a first surface of the first housing structure 210 may face a third surface of the second housing structure 220 and, in the fully unfolded state, the first surface of the first housing structure 210 and the third surface of the second housing structure 220 may face in the same direction (e.g., a direction parallel to the Z axis).

As another example, in the out-folding folded state of the electronic device 200, a second surface of the first housing structure 210 may face a fourth surface of the second housing structure 220.

Further, although not illustrated in the drawings, the electronic device 200 may include a plurality of hinge axes (e.g., two parallel hinge axes including axis A of FIG. 2 and another axis parallel to axis A) and, in this case, the electronic device 200 may be folded in a multi-folding manner which is a combination of in-folding and out-folding. For example, the plurality of hinge axes all may be arranged in the same direction. As another example, some hinge axes among the plurality of hinge axes may be arranged in different directions and be folded. Further, although not illustrated in the drawings, the hinge axis may be formed in the vertical direction or horizontal direction (e.g., a direction perpendicular to axis A) as viewed from above the electronic device 200, but is not limited thereto. For example, the hinge axis may also be formed in a diagonal direction.

The in-folding type may mean a state in which the display 250 is not exposed to the outside in the fully folded state. The out-folding type may mean a state in which the display 250 is exposed to the outside in the fully folded state, (b) of FIG. 4 illustrates an intermediate status in which the electronic device 200 is partially unfolded during in-folding.

Although the in-folded state of the electronic device 200 is described below for convenience purposes, it should be noted that the descriptions may also apply to the out-folded state of the electronic device 200.

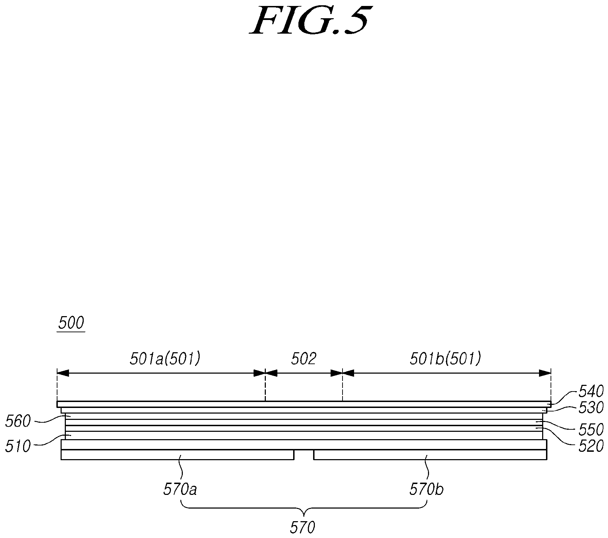

FIG. 5 is a cross-sectional view illustrating an electronic device according to various embodiments of the disclosure.

Referring to FIG. 5, a display device 500 (e.g., the display 250 of FIG. 2) according to various embodiments of the disclosure may include a display panel 510, an input sensor 520, a window 530, a protective layer 540, an anti-reflection layer 550, or an adhesive layer 560.

According to an embodiment, the display panel 510 may be provided to display an image. The display panel 510 may be, e.g., a light emitting display panel, but is not limited thereto. The display panel 510 may be, e.g., an organic light emitting display panel or a quantum dot light emitting display panel. The light emitting layer of the organic light emitting display panel may include an organic light emitting material. The light emitting layer of the quantum dot light emitting display panel may include quantum dots and quantum rods. Hereinafter, the display panel 510 is described as an organic light emitting display panel.

According to an embodiment, the display panel 510 may be a flexible display panel. Accordingly, the display panel 510 may be rolled as a whole, or may be folded or unfolded about a folding axis (e.g., the folding axis A of FIG. 2).

According to an embodiment, the input sensor 520 may be directly disposed on the display panel 510. The input sensor 520 may be formed on the display panel 510 by, e.g., a continuous process. In other words, when the input sensor 520 is directly disposed on the display panel 510, an adhesive film may not be disposed between the input sensor 520 and the display panel 510, but is not limited thereto. When the adhesive film is disposed between the input sensor 520 and the display panel 510, the input sensor 520 may not be not manufactured by a continuous process with the display panel 510, but may be manufactured by a separate process from that of the display panel 510 and then fixed to the upper surface of the display panel 510 by the adhesive film. According to another embodiment, the input sensor 520 may be patterned under a polarization layer or above an encapsulation layer of the display panel 510, or may be disposed on an internal thin film transistor (TFT) substrate of the display panel 510.

According to an embodiment, the display panel 510 may generate an image, and the input sensor 520 may obtain coordinate information for a user input (e.g., a touch event).

According to an embodiment, the window 530 may be disposed on the display panel 510 or the input sensor 520. The window 530 may include an optically transparent insulating material. Accordingly, the image generated by the display panel 510 may be easily transferred to the user through the window 530.

According to an embodiment, the window 530 may include a glass substrate or a synthetic resin film. When the window 530 is a thin film glass, e.g., the thickness of the window 530 may be 80 *µm* or less. When the window 530 is a synthetic resin film, e.g., the window 530 may include a polyimide (PI) film or a polyethylene terephthalate (PET) film.

According to an embodiment, the window 530 may transmit an image from the display panel 510 and at the same time alleviate an external impact, thereby preventing the display panel 510 from being damaged or malfunctioning due to the external impact. Here, the external impact is a force applied from the outside such as pressure and stress, and may refer to a force that causes damage to the display panel 510 or the input sensor 520.

According to an embodiment, the protective layer 540 may be disposed on the window 530. The protective layer 540 may be provided, e.g., to enhance impact resistance of the window 530 and to prevent scattering when damaged. The protective layer 540 may include at least one selected from among a urethane-based resin, an epoxy-based resin, a polyester-based resin, a polyether-based resin, an acrylate-based resin, an ABS resin, and rubber. For example, the protective layer 540 may include at least one of phenylene, polyethylene terephthalate, polyimide, polyamide (PAI), polyethylene naphthalate (PEN), and polycarbonate (PC).

According to an embodiment, the anti-reflection layer 550 may be disposed between the display panel 510 and the window 530. One or more functional layers may be disposed between the display panel 510 and the window 530, and the anti-reflection layer 550 may be disposed as one of the functional layers. The anti-reflection layer 550 may prevent the elements constituting the display panel 510 from being visually recognized from the outside by external light incident through the front surface of the display device 500. The anti-reflection layer 550 may include, e.g., a phase retarder and a polarizer. The phase retarder may be of a film type or a liquid crystal coating type, and may include a *λ*/2 phase retarder and/or a *λ*/4 phase retarder. The polarizer may also be of a film type or a liquid crystal coating type. The film type may include, e.g., a stretched synthetic resin film. The liquid crystal coating type may include, e.g., liquid crystals arranged in a predetermined arrangement. The phase retarder and the polarizer may be implemented as, e.g., one polarizing film. A protective film as a functional layer may be disposed above or below the anti-reflection layer 550.

According to an embodiment, the anti-reflection layer 550 may be disposed on the input sensor 520. In other words, the anti-reflection layer 550 may be disposed between the input sensor 520 and the window 530. The anti-reflection layer 550 and the window 530 may be coupled to each other through the adhesive layer 560. Although not shown, an adhesive film may be further disposed between the input sensor 520 and the anti-reflection layer 550. The adhesive layer 560 may include, e.g., an optically clear adhesive film (OCA). However, the adhesive layer 560 is not limited thereto, and may include a conventional adhesive. For example, the adhesive layer 560 may include an optically clear resin (OCR) or a pressure sensitive adhesive film (PSA).

According to an embodiment, the display device 500 may further include a support plate 570 disposed on the display panel 510 to support the display panel 510. The support plate 570 may be, e.g., a metal plate or a stainless steel plate. The strength of the support plate 570 may be larger than the strength of the display panel 510.

According to an embodiment, the support plate 570 may include a number of support plates 570 corresponding to the flat area 501. As the support plate 570, e.g., as illustrated, a first support plate 570a may be disposed at a position corresponding to the first flat area 501a, and a second support plate 570b may be disposed at a position corresponding to the second flat area 501b. The first support plate 570a and the second support plate 570b may be disposed to be spaced apart from each other. A portion where the first support plate 570a and the second support plate 570b are spaced apart may correspond to at least a portion of the bending area 502 (e.g., the folding area 253 of FIG. 2).

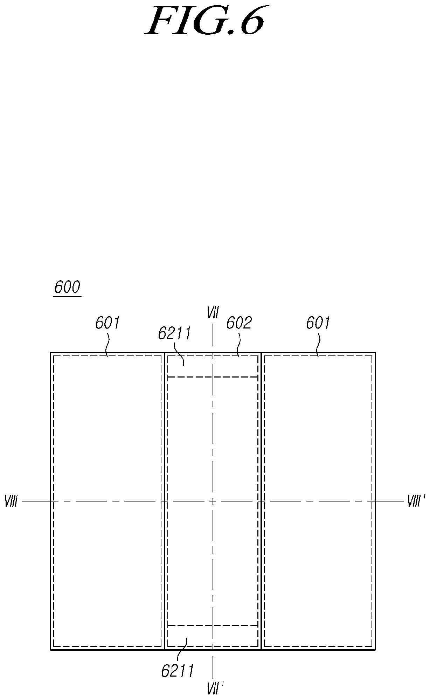

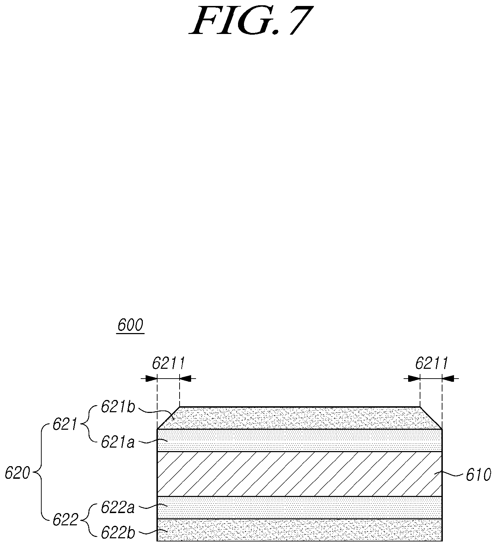

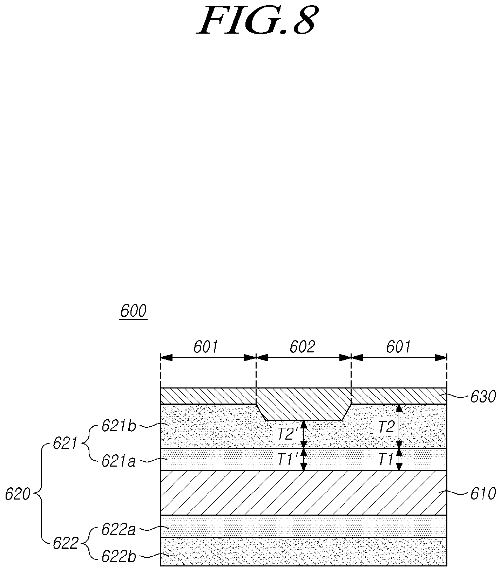

FIG. 6 is a plan view illustrating the window of FIG. 5. FIG. 7 is a cross-sectional view taken along line VII-VII' of FIG. 6. FIG. 8 is a cross-sectional view taken along line VIII-VIII' of FIG. 6;

Referring to FIGS. 6 to 8, a window 600 (e.g., the window 530 of FIG. 5) may include a base layer 610 or a coating layer 620 disposed around the base layer 610. According to an embodiment, the window 600 may be defined as at least one bending area 602 and at least one flat area 601. The bending area 602 of the window 600 may correspond to a bending area (e.g., the folding area 253 of FIG. 2) of a display device (e.g., the display 250 of FIG. 2), and the flat area 601 of the window 600 may correspond to a flat area (e.g., the first area 251 or the second area 252 of FIG. 2) of the display device 250. The description of the bending area 602 and the flat area 601 of the window 600 may be identically applied to the description of the bending area (e.g., the folding area 253) and the flat area (e.g., the first area 251 or the second area 252) of the display device 250. For convenience of description, the configuration of a refractive index matching part 630 is omitted in FIG. 7.

According to an embodiment, the base layer 610 may include a transparent material. The base layer 610 may include, e.g., glass, tempered glass, or a synthetic resin film. The base layer 610 may be, e.g., a chemically reinforced glass substrate. When the base layer 610 is a chemically reinforced glass substrate, it is possible to increase mechanical strength while having a thin thickness, and thus it may be used as a window of a flexible display. When the base layer 610 includes a synthetic resin film, the base layer 610 may include a polyimide film or a polyethylene terephthalate film. The base layer 610 may be formed of, e.g. , a flexible material.

According to an embodiment, the base layer 610 of the window 600 may have a multilayer structure or a single layer structure. The base layer 610 may have, e.g., a structure in which a plurality of synthetic resin films are coupled through an adhesive member, and may include a glass substrate and a synthetic resin film are coupled with an adhesive.

The thickness of the base layer 610 may be, e.g., 20 *µm* to 60 *µm*. The thickness of the base layer 610 may be, preferably, 20 *µm* to 40 *µm*.

According to an embodiment, the first hard coating layer 621 may be disposed on the upper surface of the base layer 610. According to an embodiment, the first hard coating layer 621 may include a plurality of coating portions having different hardnesses. According to an embodiment, the first hard coating layer 621 may include a first coating portion 621a having a first hardness and a second coating portion 621b having a second hardness different from the first hardness. In other words, the first hardness may be larger or less than the second hardness. The first hard coating layer 621 may be a layer that protects the base layer 610 from an external impact.

According to an embodiment, the thickness of the first hard coating layer 621 in the bending area 602 may be thinner than the thickness of the first hard coating layer 621 in the flat area 601. In other words, the first hard coating layer 621 may be provided in a grooved shape at a position corresponding to the bending area 602. In a portion where the bending area 602 is in contact with the flat area 601, the first hard coating layer 621 may be formed to be stepped. By configuring the thickness of the first hard coating layer 621 of the portion corresponding to the bending area 602 to be thinner than the thickness of the first hard coating layer 621 of the portion corresponding to the flat area 601, the window 600 may be more easily bent.

According to an embodiment, the thickness of the first hard coating layer 621 in the bending area 602 may be 50 *µm*. In particular, the thickness of the first hard coating layer 621 in the bending area 602 may be 10 to 30 *µm*.

According to an embodiment, in the first hard coating layer 621, one surface of the first coating portion 621a may be in contact with one surface of the base layer 610, and one surface of the second coating portion 621b may be in contact with the other surface of the first coating portion 621a. For example, in the first hard coating layer 621, the first coating portion 621a may be disposed on the upper surface of the base layer 610, and the second coating portion 621b may be disposed on the upper surface of the first coating portion 621a. When an impact is applied to the window 600 from the outside, the second coating portion may play a primary buffering role, and the first coating portion may play a secondary buffering role to prevent damage to the base layer 610, and even if the second coating portion is damaged, debris of the base layer 610 may be prevented from scattering.

According to an embodiment, in the first hard coating layer 621, a coating portion having a relatively small hardness may be disposed on the upper surface of the base layer 610, and a coating portion having a relatively large hardness may be disposed on the upper surface of the coating portion having a relatively small hardness. According to an embodiment, in the first hard coating layer 621, a coating portion having a relatively high hardness may be disposed on the upper surface of the base layer 610, and a coating portion having a relatively low hardness may be disposed on the upper surface of the coating portion having a relatively high hardness.

Hereinafter, a case in which the first coating portion 621a is disposed on the upper surface of the base layer 610 and the second coating portion 621b is disposed on the upper surface of the first coating portion 621a is described.

According to an embodiment, in the flat area 601, the thickness T1 of the first coating portion 621a and the thickness T2 of the second coating portion 621b may be substantially the same, but are not limited thereto. That thicknesses are substantially the same means not only when they are completely the same, but also when they are the same in a range including differences that may occur due to process errors despite the same design. According to an embodiment, the thickness of a coating portion having a relatively small hardness of the first coating portion 621a and the second coating portion 621b may occupy at least half of the total thickness of the first hard coating layer 621.

According to an embodiment, in the bending area 602, the thickness T1' of the first coating portion 621a may be larger than the thickness T2' of the second coating portion 621b. Further, while the thickness T1' of the first coating portion 621a in the bending area 602 and the thickness T1 of the first coating portion 621a in the flat area 601 are substantially the same, the thickness T2' of the second coating portion 621b in the bending area 602 may be thinner than the thickness T2 of the second coating portion 621b in the flat area 601. As a result, the thickness of the first hard coating layer 621 in the bending area 602 may be thinner than the thickness of the first hard coating layer 621 in the flat area 601.

According to an embodiment, the first hardness may be less than or equal to 30 kpa, and the second hardness may be larger than 30 kpa, but is not limited thereto. Hereinafter, when the second hardness is larger than the first hardness, materials of the first coating portion 621a and the second coating portion 621b are described. The first coating portion 621a may include a highly stretched polymer material having a high elongation, and may have a lower hardness than the second coating portion 621b. The first coating portion 621a may be, e.g., a portion having a lower modulus than the second coating portion 621b. The first coating portion 621a may include at least one of a urea-based material, a urethane-based material, an ester-based material, and an epoxy-based material. The first coating portion 621a may include at least one of polyurea, polyurethane, polyester, and polyepoxy.

According to an embodiment, each of the first coating portion 621a and the second coating portion 621b may include a siloxane compound. Each of the first coating portion 621a and the second coating portion 621b may include a siloxane compound as a main binder. According to an embodiment, each of the first coating portion 621a and the second coating portion 621b may include a material such as polymethylsiloxane and polydimethylsiloxane. According to an embodiment, the siloxane compound included in each of the first coating portion 621a and the second coating portion 621b may be a siloxane polymer compound or a siloxane oligomer derived from a siloxane monomer having a functional group such as an acrylate group at an end thereof. According to an embodiment, the siloxane compound may be a siloxane polymer formed by polymerizing silsesquioxane and a siloxane monomer.

According to an embodiment, each of the first coating portion 621a and the second coating portion 621b may further include a filler. The filler may include any one of a sol including inorganic particles, a nanosilica sol, or a porous sol. The filler may be spherical and may have a substantially monodisperse size distribution. The average size of the plurality of particles included in the filler may be 10 nm to 50 nm. The average size of the plurality of particles included in the filler may indicate the average diameter of the filler. For example, the average diameter of the plurality of particles included in the filler may be 10 nm or more and 30 nm or less. When the average size of the plurality of particles included in the filler exceeds 50 nm, the optical transparency of the coating portion may be deteriorated. Further, when the average size of the plurality of particles included in the filler is less than 10 nm, the effect of enhancing surface hardness in the coating portion may be reduced. The plurality of particles included in the filler may be, e.g., SiO₂, Al₂O₃, ZrO₂, ZnO, AlN, Si₃N₄ or a combination thereof. In other words, the plurality of particles may include at least one of SiO₂, Al₂O₃, ZrO₂, AlN, Si₃N₄. As an example, the composition of the coating portion may include surface treated ZrO₂ particles. Alternatively, the plurality of particles included in the filler may include nanosilica particles or porous inorganic particles.

According to an embodiment, each of the first coating portion 621a and the second coating portion 621b may further include at least one of an anti-foaming agent and a planarizing agent. The anti-foaming agent may be a material having a low surface tension, and may be a material for removing air bubbles generated when the first coating portion 621a and the second coating portion 621b are formed. The anti-foaming agent may include, e.g., a siloxane-based material. The anti-foaming agent may include, e.g., octamethylcyclotetrasiloxane. The planarizing agent is a material having a low surface tension, and may be a material for enhancing the film characteristics of the first coating portion 621a and the second coating portion 621b, i.e., the leveling characteristics, by enhancing the uniformity of the film when the first coating portion 621a and the second coating portion 621b are formed. The planarizing agent may include, e.g., a siloxane-based material. The planarizing agent may include, e.g., dimethylsiloxane.

According to an embodiment, a side portion 6211 of the bending area 602 may be formed to be thinner than other portions of the first hard coating layer 621. Here, the side portion 6211 of the bending area 602 may be a portion where the bending area 602 and the flat area 601 are not in contact with each other. The thickness of the side portion 6211 of the bending area 602 may decrease toward, e.g., an end (or edge) of the side portion 6211, as illustrated. The side portion 6211 of the bending area 602 may be treated to be inclined, e.g., in a diagonal direction. According to an embodiment, the side portion 6211 of the bending area 602 may be rounded. By thinning the side portion 6211 of the bending area 602, stress generated when the window 600 is bent may be alleviated.

According to an embodiment, the window 600 may further include a refractive index matching part 630 disposed on the outer surface of the first hard coating layer 621. Here, the outer surface may refer to a surface farthest from the base layer 610. In other words, in the illustrated embodiment, the refractive index matching part 630 may be disposed on the upper surface of the first hard coating layer 621. The refractive index matching part 630 may be disposed, e.g., at an uppermost end of the window 600 so that an upper portion thereof forms a flat surface. For example, a protective layer (e.g., the protective layer 540 of FIG. 5) may be disposed on the refractive index matching part 630. The refractive index matching part 630 may be provided to offset, e.g., a stepped structure of the first hard coating layer 621 to which differential thicknesses are applied in the bending area 602 and the flat area 601. Further, the refractive index matching part 630 may reduce a visibility issue that may occur due to the stepped structure formed on the upper surface of the first hard coating layer 621. The refractive index matching part 630 may be formed of, e.g. , a transparent material. The refractive index matching part 630 may be formed of, e.g. , urethane-based, acrylic-based, or silicon-based.

According to an embodiment, the refractive index of the refractive index matching part 630 may be substantially the same as the refractive index of the first hard coating layer 621. For example, the refractive index matching part 630 may be substantially the same as the refractive index of any one of the first coating portion 621a or the second coating portion 621b. Alternatively, the refractive indices of the refractive index matching part 630, the first coating portion 621a, and the second coating portion 621b may all be substantially the same.

According to an embodiment, the second hard coating layer 622 may be disposed on the other surface of the base layer 610. In other words, the second hard coating layer 622 may be disposed on the opposite side of the first hard coating layer 621. In the illustrated embodiment, the second hard coating layer 622 is disposed on the lower surface of the base layer 610. The second hard coating layer 622 may be disposed, e.g., on the other surface of the base layer 610 close to the display panel (e.g., the display panel 510 of FIG. 5). The second hard coating layer 622 may be a layer that protects the base layer 610 from an external impact. The second hard coating layer 622 may be a portion on which a tensile force is applied when a portion of the window 600 is bent. Accordingly, the second hard coating layer 622 may prevent the base layer 610 from being damaged by tension when the window 600 is bent due to an external impact.

According to an embodiment, the second hard coating layer 622 may include a plurality of coating portions having different hardnesses. According to an embodiment, the second hard coating layer 622 may include a third coating portion 622a having a third hardness and a fourth coating portion 622b having a fourth hardness higher than the third hardness. Here, the third coating portion 622a may correspond to the first coating portion 621a, and the fourth coating portion 622b may correspond to the second coating portion 621b. The third hardness may correspond to the first hardness of the first coating portion 621a, and the fourth hardness may correspond to the second hardness of the second coating portion 621b. Accordingly, the description of the first coating portion 621a and the second coating portion 621b may be equally applied to the description of the third coating portion 622a and the fourth coating portion 622b.

According to an embodiment, in the second hard coating layer 622, the third coating portion 622a may be disposed on the lower surface of the base layer 610, and the fourth coating portion 622b may be disposed on the lower surface of the third coating portion 622a. When an impact is applied to the window 600 from the outside, the fourth coating portion may play a primary buffering role, and the third coating portion may play a secondary buffering role to prevent damage to the base layer 610, and even if damaged, pieces of the base layer 610 may be prevented from scattering.

According to an embodiment, the configuration of one of the first hard coating layer 621 on one surface (or upper surface) of the base layer 610 or the second hard coating layer 622 on the other surface (or lower surface) of the base layer 610 may be omitted.

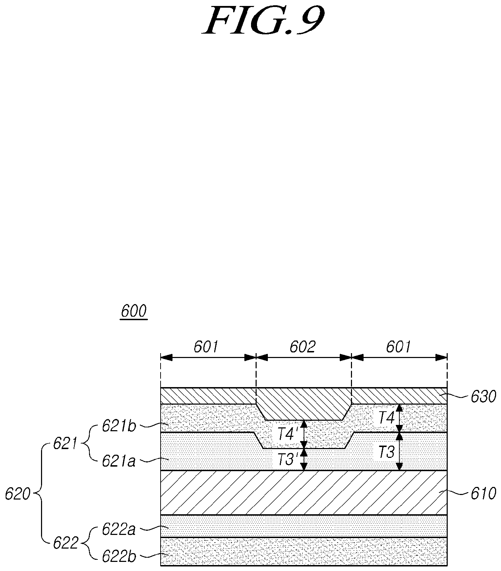

FIGS. 9 and 10 are views illustrating a window according to another embodiment of the disclosure. In describing various embodiments of the disclosure with reference to FIGS. 9 and 10, the same reference numerals are assigned to the same components as those described above, and detailed descriptions thereof will be omitted.

Referring to FIG. 9, in the flat area 601, the thickness T3 of the first coating portion 621a and the thickness T4 of the second coating portion 621b may be substantially the same, but are not limited thereto. That thicknesses are substantially the same means not only when they are completely the same, but also when they are the same in a range including differences that may occur due to process errors despite the same design.

Referring to FIG. 9, in the bending area 602, the thickness T3' of the first coating portion 621a may be smaller than the thickness T4' of the second coating portion 621b. Further, while the thickness T4' of the second coating portion 621b in the bending area 602 and the thickness T4 of the second coating portion 621b in the flat area 601 are substantially the same, the thickness T3' of the first coating portion 621a in the bending area 602 may be thinner than the thickness T3 of the first coating portion 621a in the flat area 601. As a result, the thickness of the first hard coating layer 621 in the bending area 602 may be thinner than the thickness of the first hard coating layer 621 in the flat area 601. As the thickness T3' of the first coating portion 621a in the bending area 602 is smaller than the thickness T3 of the first coating portion 621a in the flat area 601, a step of the first coating portion 621a may be formed between the bending area 602 and the flat area 601. The first coating portion 621a and the second coating portion 621b may be more stably coupled by the groove formed by such a step, thereby preventing the first coating portion 621a and the second coating portion 621b from being separated when the window 600 is bent.

Referring to FIG. 10, in the flat area 601, the thickness T5 of the first coating portion 621a and the thickness T6 of the second coating portion 621b may be substantially the same, but are not limited thereto. That thicknesses are substantially the same means not only when they are completely the same, but also when they are the same in a range including differences that may occur due to process errors despite the same design.

Referring to FIG. 10, the thickness T5' of the first coating portion 621a in the bending area 602 may be smaller than the thickness T5 of the first coating portion 621a in the flat area 601, and the thickness T6' of the second coating portion 621b in the bending area 602 may be smaller than the thickness T6 of the second coating portion 621b in the flat area 601. As a result, the thickness of the first hard coating layer 621 in the bending area 602 may be thinner than the thickness of the first hard coating layer 621 in the flat area 601. As the thickness T5' of the first coating portion 621a in the bending area 602 is smaller than the thickness T5 of the first coating portion 621a in the flat area 601, a step of the first coating portion 621a may be formed between the bending area 602 and the flat area 601. The first coating portion 621a and the second coating portion 621b may be more stably coupled by the groove formed by the step, thereby preventing the first coating portion 621a and the second coating portion 621b from being separated when the window 600 is bent. Further, by configuring the thickness T5' of the first coating portion 621a and the thickness T6' of the second coating portion 621b to be thinner in the bending area 602, the thickness of the first hard coating layer 621 may be configured to be thinner in the bending area 602.

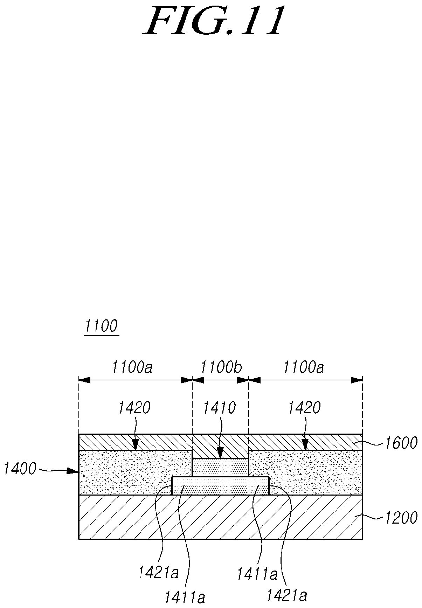

FIGS. 11 to 19 are views illustrating a window having a vertical stacked structure according to various embodiments of the disclosure. FIGS. 11 to 19 illustrate that the hard coating layer is disposed only on one surface of the base layer, but is not limited thereto. As described with reference to FIGS. 6 to 8, the hard coating layer may also be disposed on the other surface of the base layer. The first coating portion 1410 referred to in FIGS. 11 to 19 may have the same material and hardness range as the first coating portion (e.g., the first coating portion 621a of FIG. 8) described with reference to FIGS. 6 to 8, and the same manufacturing method may be applied. The second coating portion 1420 referred to in FIGS. 11 to 19 may have the same material and hardness range as the second coating portion (e.g., the second coating portion 621b of FIG. 8) described with reference to FIGS. 6 to 8, and the same manufacturing method may be applied. The base layer 1200 referred to in FIGS. 11 to 19 may be the same as the base layer (e.g., the base layer 610 of FIG. 8) described with reference to FIGS. 6 to 8. The bending area 1100b referred to in FIGS. 11 to 19 may be an area corresponding to the bending area (e.g., the bending area 602 of FIG. 8) described with reference to FIGS. 6 to 8. The flat area 1100a referred to in FIGS. 11 to 19 may be an area corresponding to the flat area (e.g., the flat area 601 of FIG. 8) described with reference to FIGS. 6 to 8.

Referring to FIGS. 11 to 19, the window 1100 according to various embodiments may include a first hard coating layer 1400 or a base layer 1200. According to various embodiments, the first hard coating layer 1400 may include a first coating portion 1410 or a second coating portion 1420. Here, the first hardness of the first coating portion 1410 may be less than the second hardness of the second coating portion 1420. At least a portion of the first coating portion 1410 may be disposed in, e.g., the bending area 1100b. At least a portion of the second coating portion 1420 may be disposed, e.g., in the flat area 1100a. The first coating portion 1410 and the second coating portion 1420 may be disposed, e.g., on different upper surfaces of the base layer 1200. Accordingly, a portion of the side surface of the first coating portion 1410 may be in contact with a portion of the side surface of the second coating portion 1420.

According to various embodiments, at a portion where the first coating portion 1410 of the bending area 1 100b is in contact with the second coating portion 1420 of the flat area 1100a, at least one protrusion 1411, at least one protrusion 1411 where a portion of the first coating portion 1410 protrudes toward the second coating portion 1420 may be formed and be coupled in the second coating portion 1420. For example, at least one protrusion 1411 may be disposed on the side surface of the first coating portion 1410 that is in contact with a portion of the side surface of the second coating portion 1420. In other words, the first coating portion 1410 may include at least one protrusion 1411 where at least a portion of a side surface in contact with the second coating portion 1420 protrudes toward the second coating portion 1420 and is inserted into the second coating portion 1420. Here, the cross-sectional shape of the protrusion 1411 may be polygonal or round.

According to various embodiments, in a portion where the first coating portion 1410 of the bending area 1 100b is in contact with the second coating portion 1420 of the flat area 1100a, the second coating portion 1420 may include at least one groove 1421 into which the protrusion 1411 of the first coating portion 1410 is inserted. For example, the at least one groove 1421 may be provided to allow the at least one protrusion 1411 to be inserted into the side surface of the second coating portion 1420 facing the at least one protrusion 1411 disposed on the side surface of the first coating portion 1410. In other words, at least one groove 1421 having a shape corresponding to the at least one protrusion 1411 may be formed in the second coating portion 1420 at a position corresponding to the at least one protrusion 1411. As the protrusion 1411 of the first coating portion 1410 is coupled to the groove 1421 of the second coating portion 1420, a coupling force between the first coating portion 1410 and the second coating portion 1420 may be enhanced, and delamination that may occur between the first coating portion 1410 and the second coating portion 1420 when the first hard coating layer 1400 is stretched by bending may be prevented.

According to various embodiments, the thickness of the first coating portion 1410 of the bending area 1 100b may be thinner than the thickness of the second coating portion 1420 of the flat area 1100a. By configuring the thickness of the coating layer in the bending area 1100b to be thin, bending performance may be enhanced. Further, as only the first coating portion 1410 having a hardness lower than the second hardness of the second coating portion 1420 is configured, compared to the embodiments of FIGS. 8 to 10, the coating layer may be thickened in the bending area 1100b, thereby enhancing impact resistance.

According to various embodiments, the window 1100 may further include a refractive index matching part 1600 disposed on the upper surface of the first hard coating layer 1400. In other words, the refractive index matching part 1600 may be disposed on the upper surfaces of each of the first coating portion 1410 and the second coating portion 1420. Here, the refractive index matching part 1600 may have the same configuration as the refractive index matching part 630 of FIG. 8.

According to an embodiment, in a portion where the second coating portion 1420 of the flat area 1100a and the first coating portion 1410 of the bending area 1 100b are in contact with each other, a portion of the second coating portion 1420 may protrude toward the first coating portion 1410 and may be coupled in the first coating portion 1410.

The embodiments illustrated in FIGS. 11 to 13 are embodiments in which the coupling structure between the first coating portion 1410 and the second coating portion 1420 has a rectangular coupling structure. Hereinafter, the embodiments illustrated in FIGS. 11 to 13 are described.

Referring to FIG. 11, the first coating portion 1410 may have a two-stage stacked structure. Each stacked structure may have a different width. According to an embodiment, at least one first protrusion 1411a may be formed at one end of the two-stage stacked structure in the first coating portion 1410. In other words, a portion of the first protruding portion 1411a of the first coating portion 1410 may be positioned in the flat area 1 100a. The first protrusion 1411a may have, e.g., a rectangular cross-sectional shape (or a right angle shape). According to an embodiment, the second coating portion 1420 may include a first groove 1421a having a rectangular cross-sectional shape (or a right angle shape) at a position corresponding to the first protrusion 1411a.

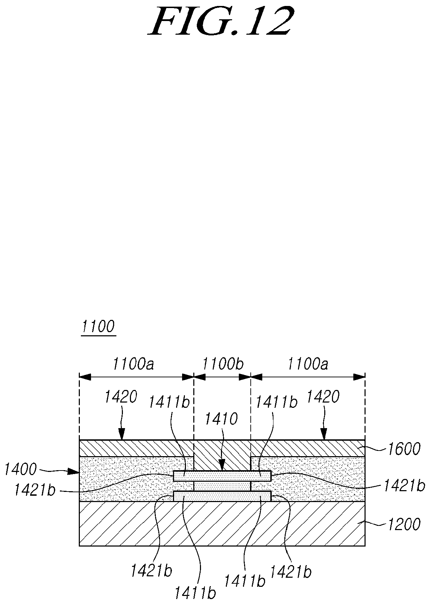

Referring to FIG. 12, the first coating portion 1410 may have a three-stage stacked structure. Each stacked structure may have a different width. According to an embodiment, in the first coating portion 1410, at least one second protrusion 1411b may be formed at an upper end and a lower end of the three-stage stacked structure. In other words, a portion of the second protrusion 1411b in the first coating portion 1410 may be positioned in the flat area 1100a. The second protrusion 1411b may have, e.g., a rectangular cross-sectional shape (or a right angle shape). According to an embodiment, the second coating portion 1420 may include a second groove 1421b having a rectangular cross-sectional shape (or a right angle shape) at a position corresponding to the second protrusion 1411b.

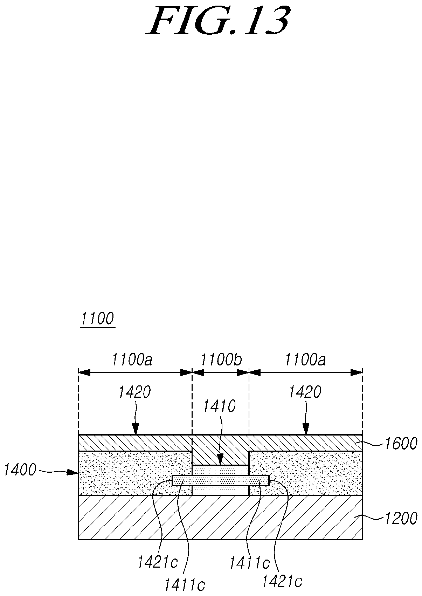

Referring to FIG. 13, the first coating portion 1410 may have a three-stage stacked structure. Each stacked structure may have a different width. According to an embodiment, at least one third protrusion 1411c may be formed at an intermediate end of the three-stage stacked structure in the first coating portion 1410. In other words, a portion of the third protrusion 1411c in the first coating portion 1410 may be positioned in the flat area 1100a. The third protrusion 1411c may have, e.g., a rectangular cross-sectional shape (or a right angle shape). According to an embodiment, the second coating portion 1420 may include a third groove 1421c having a rectangular cross-sectional shape (or a right angle shape) at a position corresponding to the third protrusion 1411c.

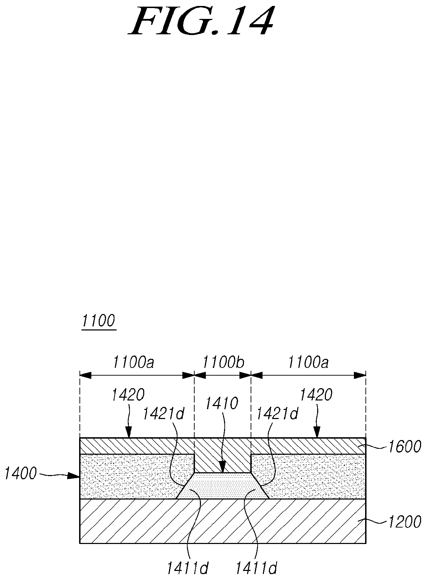

The embodiments illustrated in FIGS. 14 to 16 are embodiments in which the coupling structure between the first coating portion 1410 and the second coating portion 1420 has a diagonal coupling structure. Hereinafter, the embodiments illustrated in FIGS. 14 to 16 are described.

Referring to FIG. 14, at least one fourth protrusion 1411d may be formed in the first coating portion 1410. In other words, a portion of the fourth protrusion 1411d in the first coating portion 1410 may be positioned in the flat area 1100a. The fourth protrusion 1411d may have, e.g., a triangular cross-sectional shape (or a diagonal shape). According to an embodiment, the second coating portion 1420 may include a fourth groove 1421d having a triangular cross-sectional shape (or a diagonal shape) at a position corresponding to the fourth protrusion 1411d.

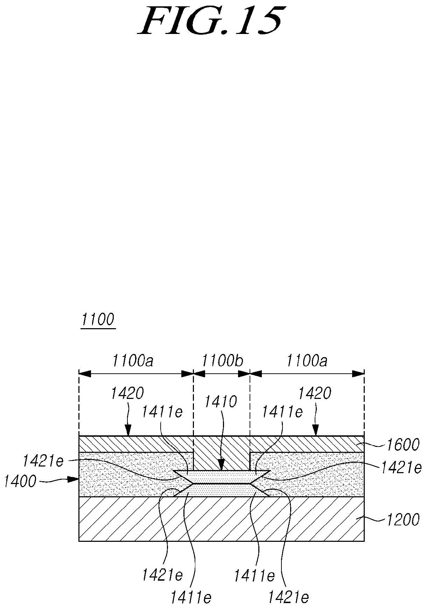

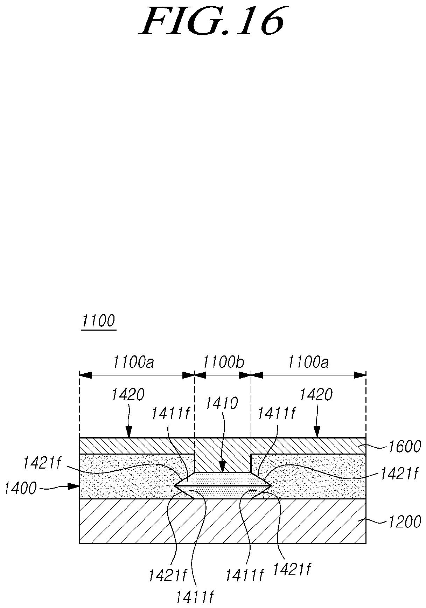

Referring to FIGS. 15 and 16, the first coating portion 1410 may have a two-stage stacked structure. Each end of the first coating portion 1410 may include at least one protrusion (a fifth protrusion 1411e or a sixth protrusion 1411f). Each of the fifth protrusion 1411e or the sixth protrusion 1411f may have a triangular cross-sectional shape (or a diagonal shape), but may have a different protruding shape in a different diagonal direction. According to an embodiment, the second coating portion 1420 may include a fifth groove 1421e or a sixth groove 1421f having a shape corresponding to the fifth protrusion 1411e or the sixth protrusion 1411f at a position corresponding to the fifth protrusion 1411e or the sixth protrusion 141 1f.

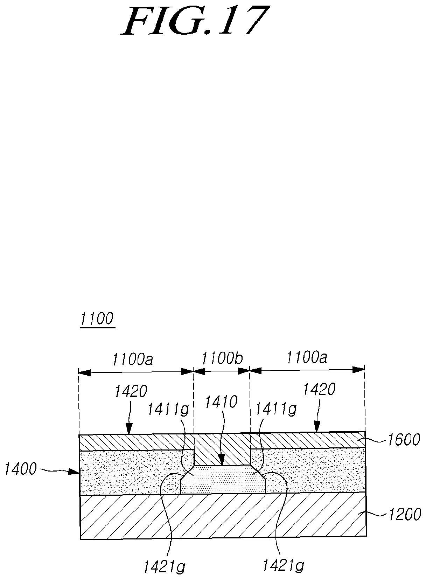

The embodiments illustrated in FIGS. 17 to 19 are embodiments in which the coupling structure between the first coating portion 1410 and the second coating portion 1420 has a right angle/diagonal combined coupling structure. Hereinafter, the embodiments illustrated in FIGS. 17 to 19 are described.

Referring to FIG. 17, at least one seventh protrusion 1411g may be formed in the first coating portion 1410. In other words, a portion of the seventh protrusion 1411g of the first coating portion 1410 may be positioned in the flat area 1100a. The seventh protrusion 1411g may have, e.g., a polygonal cross-sectional shape (or a right angle/diagonal combined shape). According to an embodiment, the second coating portion 1420 may include a seventh groove 1421g having a polygonal cross-sectional shape (or a right angle/diagonal combined shape) at a position corresponding to the seventh protrusion 1411g.

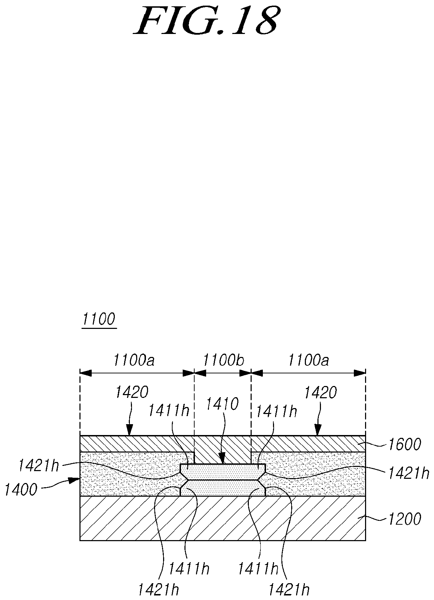

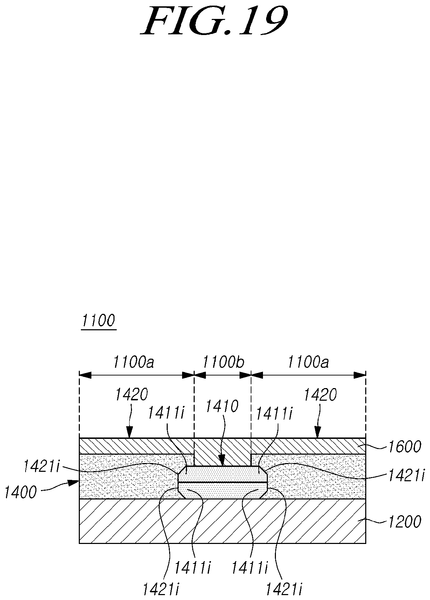

Referring to FIGS. 18 and 19, the first coating portion 1410 may have a two-stage stacked structure. Each end of the first coating portion 1410 may include at least one protrusion (the eighth protrusion 1411h or the ninth protrusion 1411i). Each of the eighth protrusion 1411h or the ninth protrusion 1411i may have a polygonal cross-sectional shape (or a right angle/diagonal combined shape), but may have a different protruding shape in a different right angle/diagonal direction. According to an embodiment, the second coating portion 1420 may include an eighth groove 1421h or a ninth groove 1421i having a shape corresponding to the eighth protrusion 1411h or the ninth protrusion 1411i at a position corresponding to the eighth protrusion 1411h or the ninth protrusion 1411i.

The disclosure is not limited to the above-described embodiments, and may include embodiments that may easily be combined by one of ordinary skill in the art through a combination of the drawings.

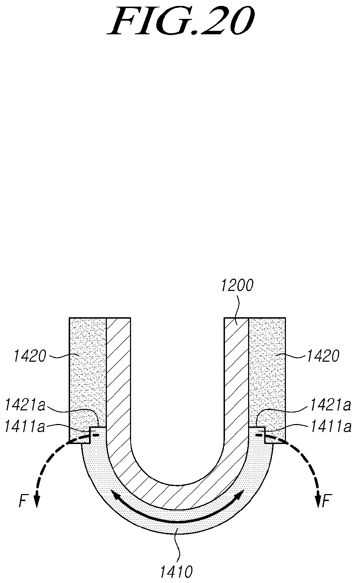

FIG. 20 is a view illustrating a first of a window having a vertical stacked structure according to various embodiments of the disclosure. In describing various embodiments of the disclosure with reference to FIG. 20, the same reference numerals are assigned to the same components as those described above, and detailed descriptions thereof will be omitted.

As illustrated, when the window 1100 is out-folded, the first hard coating layer 1400 may be tensioned. When the first hard coating layer 1400 is tensioned, a force may be applied in a direction F opposite to the direction in which the first coating portion 1410 is out-folded by the tensile force. Here, the protrusion 1411 of the first coating portion 1410 may be fixed to the groove 1421 of the second coating portion 1420 to prevent two opposite ends of the first coating portion 1410 from moving and delaminating in the F direction. In other words, a portion of the groove 1421 of the second coating portion 1420 may serve as a stop jaw for fixing the first coating portion 1410. FIG. 20 has been described with reference to the embodiment of FIG. 11 having the shapes of the first protrusion 1411a and the first groove 1421a. However, like the embodiments illustrated in FIGS. 12 to 19, when the first hard coating layer 1400 is tensioned, the protrusions 1411b to 1411i and the grooves 1421b to 1421i may prevent delamination between the first coating portion 1410 and the second coating portion 1420.

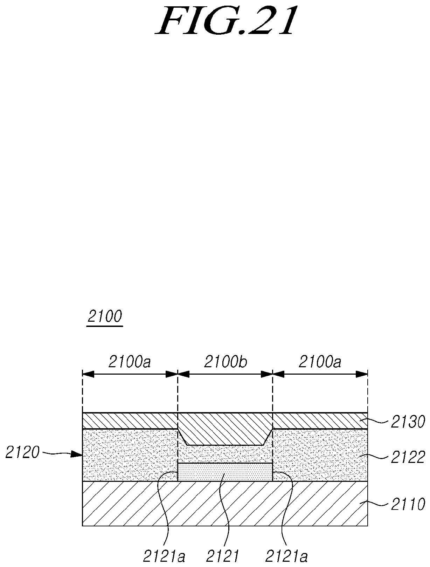

FIGS. 21 to 23 are views illustrating a window having an embedded structure according to various embodiments of the disclosure. FIGS. 21 to 23 illustrate that the hard coating layer is disposed only on one surface of the base layer, but is not limited thereto. As described with reference to FIGS. 6 to 8, the hard coating layer may also be disposed on the other surface of the base layer. The first coating portion 2121 referred to in FIGS. 21 to 23 may have the same material and hardness range as the first coating portion (e.g., the first coating portion 621a of FIG. 8) described with reference to FIGS. 6 to 8, and the same manufacturing method may be applied. The second coating portion 2122 referred to in FIGS. 21 to 23 may have the same material and hardness range as the second coating portion (e.g., the second coating portion 621b of FIG. 8) described with reference to FIGS. 6 to 8, and the same manufacturing method may be applied. The base layer 2110 referred to in FIGS. 21 to 23 may be the same as the base layer (e.g., the base layer 610 of FIG. 8) described with reference to FIGS. 6 to 8. The bending area 2100b referred to in FIGS. 21 to 23 may be an area corresponding to the bending area (e.g., the bending area 602 of FIG. 8) described with reference to FIGS. 6 to 8. The flat area 2100a referred to in FIGS. 21 to 23 may be an area corresponding to the flat area (e.g., the flat area 601 of FIG. 8) described with reference to FIGS. 6 to 8.

Referring to FIGS. 21 to 23, the window 2100 according to various embodiments may include a first hard coating layer 2120 or a base layer 2110. According to various embodiments, the first hard coating layer 2120 may include a first coating portion 2121 or a second coating portion 2122. Here, the first hardness of the first coating portion 2121 may be less than the second hardness of the second coating portion 2122. For example, at least a portion of the first coating portion 2121 may be disposed in the bending area 2100b. The second coating portion 2122 may be disposed in, e.g., the flat area 2100a and the bending area 2100b. The second coating portion 2122, e.g., may be disposed to surround the first coating portion 2121. In other words, the second coating portion 2122 may be disposed to contact the upper surface and the side surface of the first coating portion 2121. As a result, the first hard coating layer 2120 may be formed in a structure in which the first coating portion 2121 is embedded in the second coating portion 2122. As the first coating portion 2121 is embedded in the second coating portion 2122, the first coating portion 2121 is stably embedded when the window 2100 is bent, so that the coupling performance of the first coating portion 2121 and the second coating portion 2122 may be further enhanced.

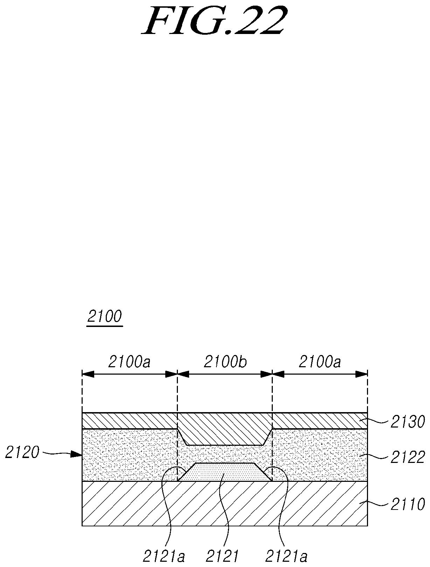

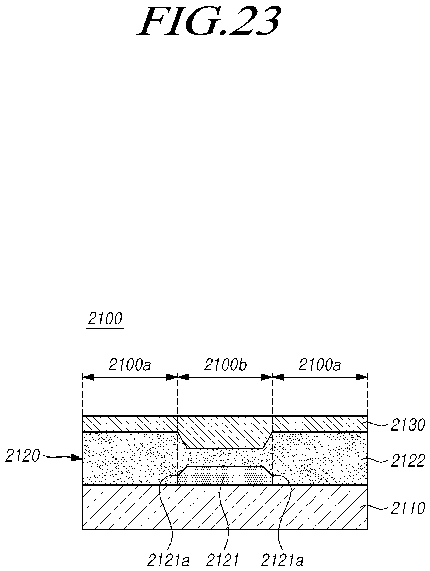

According to various embodiments, an end portion 2121a of the first coating portion 2121 may be formed in a rectangular shape as shown in FIG. 21, a diagonal shape as shown in FIG. 22, or a right angle/diagonal combined shape as shown in FIG. 23.

According to various embodiments, the thickness of the first hard coating layer 2120 in the bending area 2100b may be thinner than the thickness of the first hard coating layer 2120 in the flat area 2100a.

According to various embodiments, the window 2100 may further include a refractive index matching part 2130 disposed on the upper surface of the first hard coating layer 2120. In other words, the refractive index matching part 2130 may be disposed on the upper surface of the second coating unit 2122. Here, since the first coating portion 2121 is embedded by the second coating portion 2122, the first coating portion 2121 may not be in contact with the refractive index matching part 2130. Here, the refractive index matching part 2130 may have the same configuration as the refractive index matching part 630 of FIG. 8.

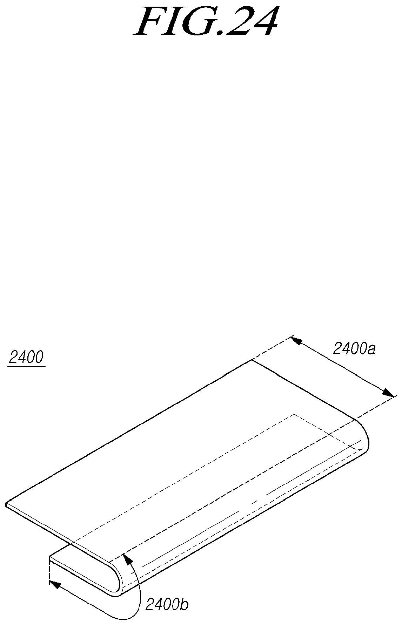

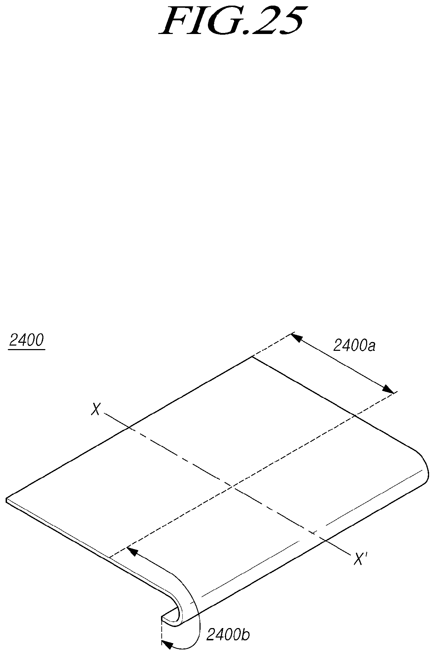

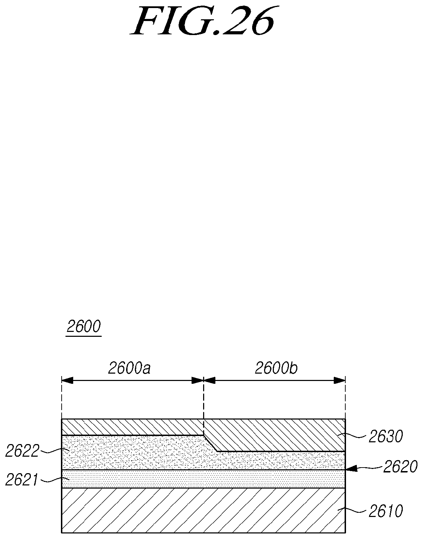

FIGS. 24 to 28 are views illustrating a window structure applied to a rollable display device according to various embodiments of the disclosure. FIGS. 24 and 25 are views illustrating a process of enlarging and reducing a screen of a rollable display device 2400. FIGS. 26 to 28 are views illustrating embodiments of a window 2600 applied to a rollable display device 2400 among various embodiments of the disclosure. FIGS. 26 to 28 illustrate that the hard coating layer is disposed only on one surface of the base layer, but is not limited thereto. As described with reference to FIGS. 6 to 8, the hard coating layer may also be disposed on the other surface of the base layer. The first coating portion 2621 referred to in FIGS. 26 to 28 may have the same material and hardness range as the first coating portion (e.g., the first coating portion 621a of FIG. 8) described with reference to FIGS. 6 to 8, and the same manufacturing method may be applied. The second coating portion 2622 referred to in FIGS. 26 to 28 may have the same material and hardness range as the second coating portion (e.g., the second coating portion 621b of FIG. 8) described with reference to FIGS. 6 to 8, and the same manufacturing method may be applied. The base layer 2610 referred to in FIGS. 26 to 28 may be the same as the base layer (e.g., the base layer 610 of FIG. 8) described with reference to FIGS. 6 to 8.

Referring to FIGS. 24 and 25, the rollable display device 2400 may be defined by a flat area 2400a and a bending area 2400b (or a rolling area). The flat area 2400a may be, e.g., an area in which a flat surface is maintained regardless of enlargement or reduction of the flat portion of the rollable display device 2400. The bending area 2400b may be, e.g., an area rolled as the flat portion of the rollable display device 2400 is enlarged or reduced.

FIGS. 26 to 28 are cross-sectional views illustrating the rollable display device 2400 of FIG. 25 taken along line X-X'. The flat area 2600a of the window 2600 may correspond to the flat area 2400a of the rollable display device 2400. The bending area 2600b of the window 2600 may correspond to the bending area 2400b of the rollable display device 2400.

According to various embodiments, the thickness of the first hard coating layers 2620, 2640, and 2650 in the bending area 2600b may be thinner than the thickness of the first hard coating layers 2620, 2640, and 2650 in the flat area 2600a. The first hard coating layers 2620, 2640, and 2650 may have a step formed at a portion where the flat area 2600a and the bending area 2600b are in contact with each other. By configuring the thickness of the first hard coating layers 2620, 2640, and 2650 of the portion corresponding to the bending area 2600b to be thinner than the thickness of the first hard coating layers 2620, 2640, and 2650 of the portion corresponding to the flat area 2600a, the window 2600 may be more easily bent (or rolled).

According to an embodiment, as illustrated in FIG. 26, the first hard coating layer 2620 of the window 2600 disposed on the rollable display device 2400 may have a horizontal stacked structure. Further, by horizontally stacking the first coating portion 2621 and the second coating portion 2622 having different hardness on the upper portion of the base layer 2610, the impact resistance performance may be enhanced compared to when one type of coating portion is used. A refractive index matching part 2630 may be disposed on the first hard coating layer 2620.

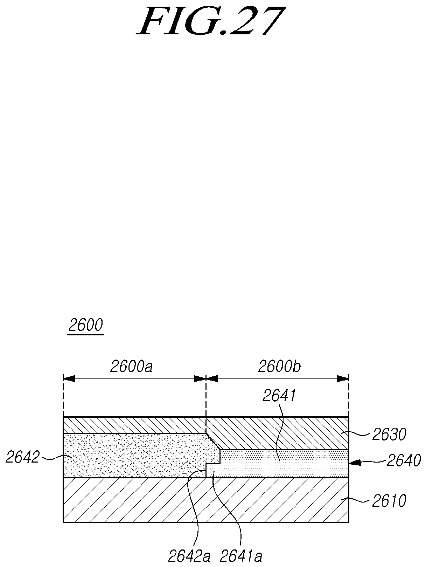

According to an embodiment, as illustrated in FIG. 27, the first hard coating layer 2640 of the window 2600 disposed on the rollable display device 2400 may have a vertical stacked structure. According to an embodiment, at least a portion of the first coating portion 2641 may be disposed in the bending area 2600b. According to an embodiment, at least a portion of the second coating portion 2642 may be disposed in the flat area 2600a. The first coating portion 2641 and the second coating portion 2642 may be disposed, e.g., on different upper surfaces of the base layer 2610. The thickness of the first coating portion 2641 may be thinner than the thickness of the second coating portion 2642.

According to an embodiment, at a portion where the first coating portion 2641 is in contact with the second coating portion 2642, at least one protrusion 1411, at least one protrusion 2641a where a portion of the first coating portion 2641 protrudes toward the second coating portion 2642 may be formed and be coupled in the second coating portion 2642. According to an embodiment, the second coating portion 2642 may include a groove 2642a into which the protrusion 2641a is inserted. Here, the first hardness of the first coating portion 2641 may be less than the second hardness of the second coating portion 2642. The coupling of the protrusion 2641a and the groove 2642a may strengthen the coupling between the first coating portion 2641 and the second coating portion 2642 and prevent delamination due to the tensile force.

Although FIG. 27 illustrates that the protrusion 2641a has a right angle shape, the disclosure is not limited thereto, and the protrusion 2641a may have a shape corresponding to FIGS. 12 to 19.

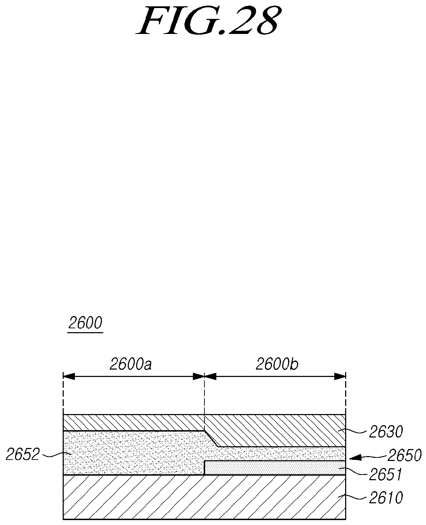

According to an embodiment, as illustrated in FIG. 28, the first hard coating layer 2650 of the window 2600 disposed in the rollable display device 2400 may have a semi-embedded type stacked structure. According to an embodiment, at least a portion of the first coating portion 2651 may be disposed in the bending area 2600b. According to an embodiment, the second coating portion 2652 may be disposed in the flat area 2600a and the bending area 2600b. The second coating portion 2652 may be disposed to surround, e.g., a portion of a side surface and an upper surface of the first coating portion 2651. Here, the first hardness of the first coating portion 2651 may be less than the second hardness of the second coating portion 2652. The first coating portion 2651 may be coupled to be partially surrounded by the second coating portion 2652, thereby preventing delamination during bending.

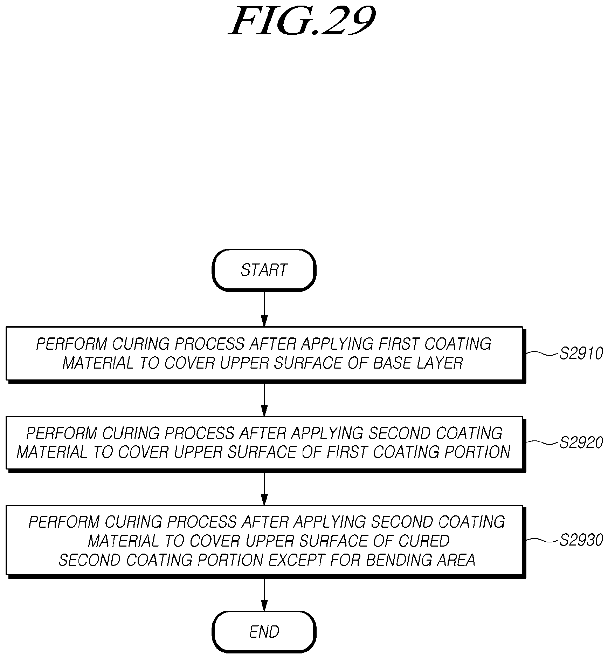

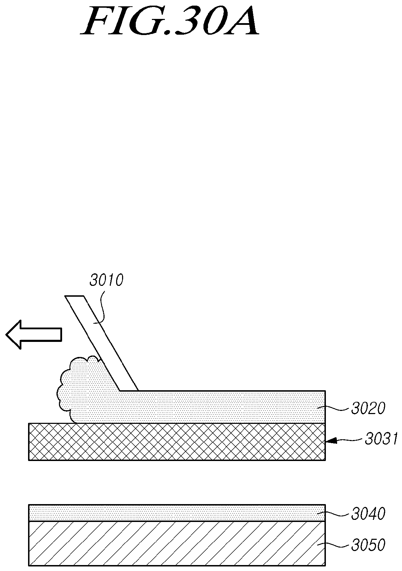

FIG. 29 is a flowchart illustrating a method for manufacturing a horizontal stacked structure of a window according to various embodiments of the disclosure. FIGS. 30A to 30C are views illustrating an example of a method for manufacturing a horizontal stacked structure of a window according to various embodiments of the disclosure.

The first coating portion 3040 referred to in FIGS. 29 to 30C may have the same material and hardness range as the first coating portion (e.g., the first coating portion 621a of FIG. 8) described with reference to FIGS. 6 to 8, and the same manufacturing method may be applied. The second coating portion 3070 referred to in FIGS. 29 to 30C may have the same material and hardness range as the second coating portion (e.g., the second coating portion 621b of FIG. 8) described with reference to FIGS. 6 to 8, and the same manufacturing method may be applied.

According to various embodiments, the hard coating layer in the window may be manufactured by a silk screen coating method. After silk screens 3031, 3032, and 3033 are mounted on an upper portion spaced apart from the base layer 3050 seated on the upper portion of the stage, a liquid composition may be dropped on the upper portion of the silk screens 3031, 3032, and 3033. The composition dropped to the upper portion of the silk screen 3031, 3032, and 3033 may be pushed into the mesh portion of the silk screen 3031, 3032, and 3033 by the squeeze 3010 and applied to the upper portion of the base layer 3050. The thickness of the coated coating material may be adjusted by adjusting the thickness of the mesh portions of the silk screens 3031, 3032, and 3033. The composition applied to the upper portion of the base layer 3050 may form a portion of the hard coating layer through a curing process. The applied composition may be cured in a high temperature state by, e.g., one or more of heat, ultraviolet(UV), IR, and microwaves.

Hereinafter, a method for manufacturing a hard coating layer having a horizontal stacked structure using a silk screen coating method is described in detail.

After the first coating material 3020 is applied to cover the upper surface of the base layer 3050, a curing process may be performed at operation S2910. Process at operation S2910 may correspond to FIG. 30A. Here, the first coating material 3020 may be a composition of the first coating portion 3040. After the first coating material 3020 is dropped on a first silk screen 3031, the first coating material 3020 may pass through the mesh of the first silk screen 3031 using the squeeze 3010. In this process, the first coating material 3020 may be applied to the overall space of the upper surface of the base layer 3050 through the mesh portion of the first silk screen 3031. A mesh through which the first coating material 3020 may pass may be formed in a portion corresponding to the upper surface of the base layer 3050. After the first coating material 3020 is applied, the first coating portion 3040 may be formed through a curing process.

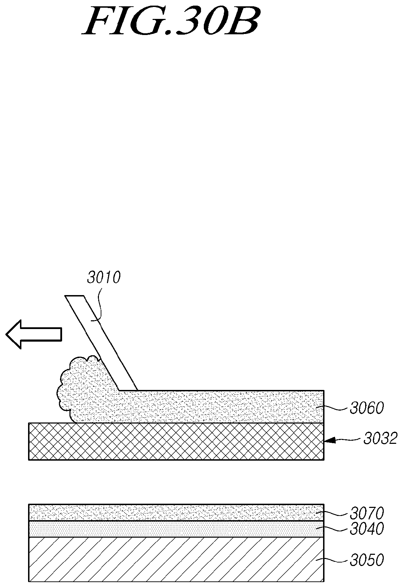

After forming the first coating portion 3040, the second coating material 3060 may be applied to cover the upper surface of the first coating portion 3040, and then the curing process may be performed at operation S2920. Process at operation S2920 may correspond to FIG. 30B. Here, the second coating material 3060 may be a composition of the second coating portion 3070. After the second coating material 3060 is dropped on the second silk screen 3032, the second coating material 3060 may pass through the mesh of the second silk screen 3032 using the squeeze 3010. In this process, the second coating material 3060 may be applied to the overall space of the upper surface of the first coating portion 3040 through the mesh portion of the second silk screen 3032. In the second silk screen 3032, a mesh may be formed to allow the second coating material 3060 to pass through a portion corresponding to the upper surface of the first coating portion 3040. The second silk screen 3032 may have the same shape as the first silk screen 3031. After the second coating material 3060 is applied, the second coating portion 3070 may be formed on the first coating portion 3040 through a curing process. In the state in which process S2920 is completed, the thickness of the hard coating layer in the flat area (e.g., the flat area 601 of FIG. 6) and the thickness of the hard coating layer in the bending area (e.g., the bending area 602 of FIG. 6) may be the same. Through the next process, a difference may be formed between the thickness of the hard coating layer in the flat area 601 and the thickness of the hard coating layer in the bending area 602.

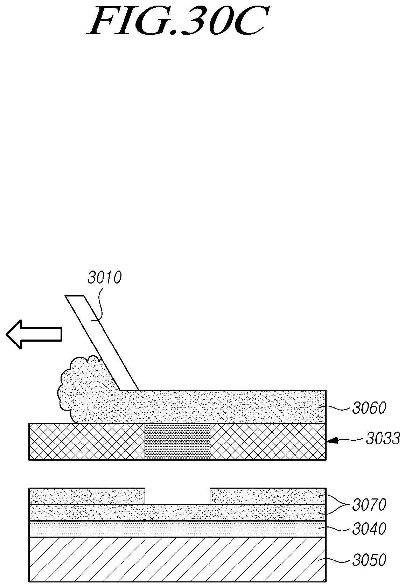

After the process at operation S2920 is completed, the curing process may be performed after the second coating material 3060 is applied to cover the upper surface of the cured second coating portion 3070 except for the bending area 602 at operation S2930. The second coating material 3060 may be applied to cover, e.g., the flat area 601 of the cured second coating portion 3070. Process at operation S2930 may correspond to FIG. 30C. According to an embodiment, in process at operation S2920, the second coating material 3060 may be applied to cover a portion of the bending area 602. After the second coating material 3060 is dropped on the third silk screen 3033, the second coating material 3060 may pass through the mesh of the third silk screen 3033 using the squeeze 3010. In this process, the second coating material 3060 may be applied to a portion corresponding to the flat area 601 through the mesh portion of the third silk screen 3033. In the third silk screen 3033, a mesh may be formed so that the second coating material 3060 may penetrate only a portion corresponding to the flat area 601. By process S2930, a thickness difference in the hard coating layer may be formed between the bending area 602 and the flat area 601.

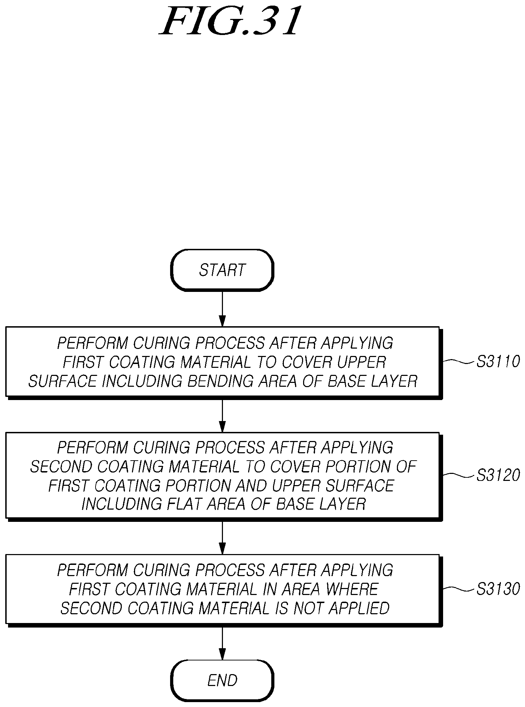

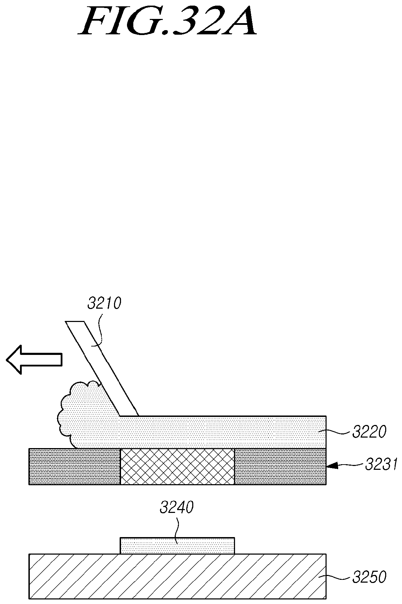

FIG. 31 is a view illustrating an example of a method for manufacturing a vertical stacked structure of a window according to various embodiments of the disclosure. FIGS. 32A to 32C are views illustrating an example of a method for manufacturing a vertical stacked structure of a window according to various embodiments of the disclosure.

The first coating portion 3240 referred to in FIGS. 31 to 32C may have the same material and hardness range as the first coating portion (e.g., the first coating portion 1410 of FIG. 11) described with reference to FIGS. 11 to 19, and the same manufacturing method may be applied. The second coating portion 3270 referred to in FIGS. 31 to 32C may have the same material and hardness range as the second coating portion (e.g., the second coating portion 1420 of FIG. 11) described with reference to FIGS. 11 to 19, and the same manufacturing method may be applied.

Hereinafter, a method for manufacturing a hard coating layer having a horizontal stacked structure using a silk screen coating method is described in detail.

After the first coating material 3220 is applied to cover the upper surface including the bending area (e.g., the bending area 1100b of FIG. 11) of the base layer 3250, a curing process may be performed at operation S3110. Process at operation S3110 may correspond to FIG. 32A. Here, the first coating material 3220 may be a composition of the first coating portion 3240. After the first coating material 3220 is dropped on the fourth silk screen 3231, the first coating material 3220 may pass through the mesh of the fourth silk screen 3231 using the squeeze 3210. In this process, the first coating material 3220 may be applied to the overall space of the bending area 1100b of the base layer 3250 through the mesh portion of the fourth silk screen 3231. In the fourth silk screen 3231, a mesh may be formed to allow the first coating material 3220 to pass through a portion corresponding to the bending area 1100b of the base layer 3250. After the first coating material 3220 is applied, the first coating portion 3240 may be formed through a curing process.

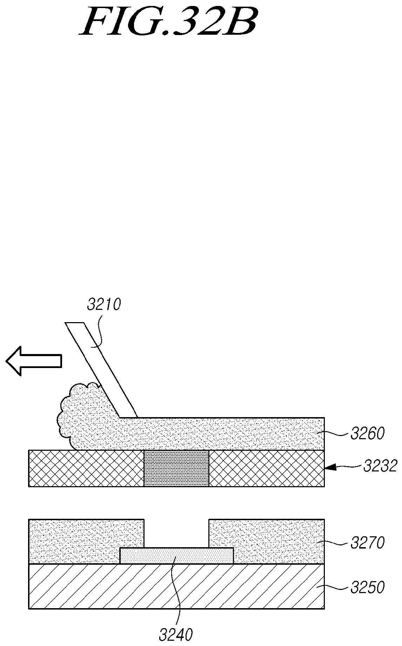

After the first coating portion 3240 is formed, the second coating material 326 may be applied to cover the upper surface including the flat area (e.g., the flat area 1100a of FIG. 11) of the base layer 3250 and a portion of the first coating portion 3240 and then the curing process may be performed at operation S3120. Process at operation S3120 may correspond to FIG. 32B. Here, the second coating material 3260 may be a composition of the second coating portion 3270. After the second coating material 3260 is dropped on the fifth silk screen 3232, the second coating material 3260 may pass through the mesh of the fifth silk screen 3232 using the squeeze 3210. In this process, the second coating material 3260 may be applied to a portion of the widthwise end portion of the upper surface of the first coating portion 3240 and the flat area 1100a of the base layer 3250 through the mesh portion of the fifth silk screen 3232. In the fifth silk screen 3232, a mesh may be formed to allow the second coating material 3260 to pass through a portion of the widthwise end portion of the upper surface of the first coating portion 3240 and a portion corresponding to the flat area 1100a of the base layer 3250. After the second coating material 3260 is applied, the second coating portion 3270 may be formed through a curing process.

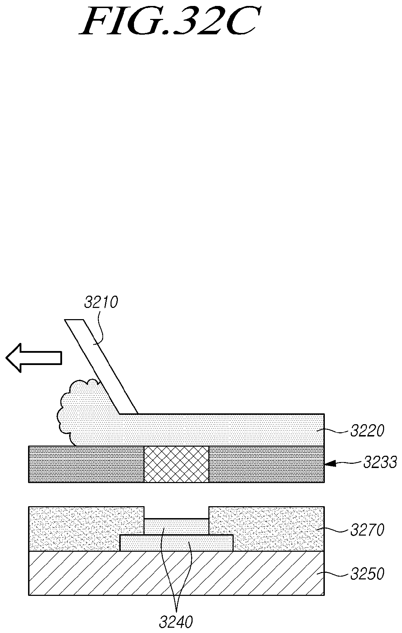

After the process at operation S3120 is completed, the curing process may be performed after the first coating material is applied to an area where the second coating material is not applied at operation S3130. Here, the first coating material 3220 may be applied to contact, e.g., a portion of the upper surface of the first coating portion 3240 cured in process S3110. The first coating material 3220 may be applied, e.g., in the bending area 1100b. Process S3130 may correspond to FIG. 32C. After the first coating material 3220 is dropped on the sixth silk screen 3233, the first coating material 3220 may pass through the mesh of the sixth silk screen 3233 using the squeeze 3210. In this process, the first coating material 3220 may be applied through the mesh portion of the sixth silk screen 3233. In the sixth silk screen 3233, a mesh may be formed so that the first coating material 3220 may penetrate only a portion corresponding to a portion of the bending area 1100b. The mesh of the sixth silk screen 3233 may be formed at a position overlapping the mesh of the fourth silk screen 3231, and the width of the mesh of the sixth silk screen 3233 may be smaller than the width of the mesh of the fourth silk screen 3231.

FIGS. 32A to 32C illustrate the embodiment illustrated in FIG. 11 among various embodiments of the vertical stacked structure illustrated, and other embodiments illustrated in FIGS. 12 to 19 may also be manufactured using a silk screen coating method by adjusting the viscosity of the composition.

FIGS. 29 to 32C have been described with reference to an example of a horizontal stacked structure and a method for manufacturing an example of a vertical stacked structure, but the disclosure is not limited thereto, and various embodiments of the disclosure may be implemented using the silk screen coating method described with reference to FIGS. 29 to 32C.

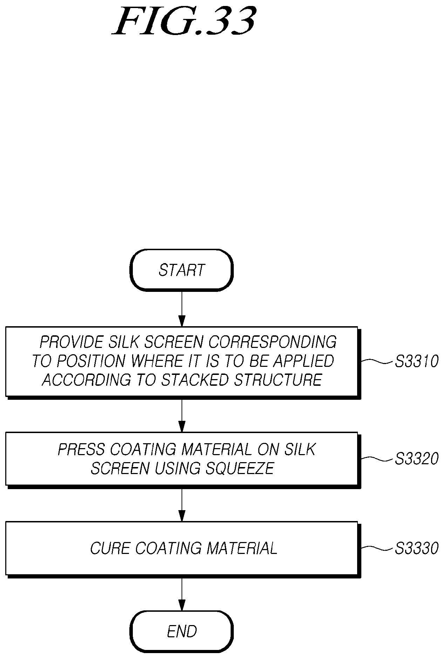

FIG. 33 is a flowchart illustrating a process of applying a coating portion of a base layer of a window according to various embodiments of the disclosure.

According to the stacked structure, a silk screen corresponding to a position to be applied may be provided at operation S3310. Here, the silk screen may be one of the first to sixth silk screens 3031, 3032, 3033, 3231, 3232, and 3233 described with reference to FIGS. 29 to 32C, and may be a silk screen having various mesh patterns.

After completing process at operation S3310, the coating material may be pressed on the silk screen using the squeeze 3010 or 3210 at operation S3320. When the coating material is pressed on the silk screen, the coating material may penetrate only the mesh portion so that the coating material may be applied on the desired portion.

After completing process at operation S3320, the coating material may be cured at operation S3330.

As a hard coating layer including coating portions having different hardnesses, a hard coating layer having a difference in thickness between the flat area and the bending area may be manufactured by repeating processes at operation S3310 to S3330.

The terms as used herein are provided merely to describe some embodiments thereof, but are not intended to limit the disclosure. As used herein, the singular forms "a," "an," and "the" are intended to include the plural forms as well, unless the context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, the term 'and/or' should be understood as encompassing any and all possible combinations by one or more of the enumerated items. As used herein, the terms "include," "have," and "comprise" are used merely to designate the presence of the feature, component, part, or a combination thereof described herein, but use of the term does not exclude the likelihood of presence or adding one or more other features, components, parts, or combinations thereof. As used herein, the terms "first" and "second" may modify various components regardless of importance and/or order and are used to distinguish a component from another without limiting the components.

As used herein, the terms "configured to" may be interchangeably used with the terms "suitable for," "having the capacity to," "designed to," "adapted to," "made to," or "capable of" depending on circumstances. The term "configured to" does not essentially mean "specifically designed in hardware to." Rather, the term "configured to" may mean that a device can perform an operation together with another device or parts. For example, a `device configured (or set) to perform A, B, and C' may be a dedicated device to perform the corresponding operation or may mean a general-purpose device capable of various operations including the corresponding operation.

Meanwhile, the terms "upper side", "lower side", and "front and rear directions" used in the disclosure are defined with respect to the drawings, and the shape and position of each component are not limited by these terms.

In the disclosure, the above-described description has been made mainly of specific embodiments, but the disclosure is not limited to such specific embodiments, but should rather be appreciated as covering all various modifications, equivalents, and/or substitutes of various embodiments.

A display device (e.g., the display device 500 of FIG. 5) according to an embodiment of the disclosure may comprise a display panel (e.g., the display panel 510 of FIG. 5), a window (e.g., the window 530 of FIG. 5 or the window 600 of FIG. 7) disposed on the display panel, the window including a bending area (e.g., the bending area 502 of FIG. 5) and a flat area (e.g., the flat area 501 of FIG. 5). The window may include a base layer (e.g., the base layer 610 of FIG. 7), and a first hard coating layer (e.g., the first hard coating layer 621 of FIG. 7) disposed on one surface of the base layer and including a plurality of coating portions (e.g., the first coating portion 621a or the second coating portion 621b of FIG. 7) having different hardnesses. A thickness of the first hard coating layer disposed on the flat area may be larger than a thickness of the first hard coating layer disposed on the bending area.

According to an embodiment of the disclosure, the plurality of coating portions may include a second coating portion is stacked on an upper surface of a first coating portion. In the first hard coating layer, one surface of the first coating portion may contact one surface of the base layer, and another surface of the first coating portion may contact one surface of a second coating portion.

According to an embodiment of the disclosure, a thickness of the first coating portion is relatively thinner in the bending area than in the flat area.

According to an embodiment of the disclosure, the plurality of coating portions may include a first coating portion disposed in the bending area and a second coating portion disposed in the flat area. A first hardness of the first coating portion may be less than a second hardness of the second coating portion. The first hard coating layer may be disposed so that a portion of a side surface of the first coating portion and a portion of a side surface of the second coating portion contact each other.

According to an embodiment of the disclosure, at least one protrusion (e.g., the first protrusion 1411a of FIG. 11) may be disposed on a side surface of the first coating portion contacting the portion of the side surface of the second coating portion. At least one groove (e.g., the first groove 1421a of FIG. 11) may be provided to allow the at least one protrusion to be inserted into the side surface of the second coating portion opposite to the at least one protrusion disposed on the side surface of the first coating portion.

According to an embodiment of the disclosure, the at least one protrusion may have a polygonal cross-sectional shape.

According to an embodiment of the disclosure, at least one protrusion may be disposed on the side surface of the second coating portion contacting the portion of the side surface of the first coating portion. At least one groove may be disposed to allow the at least one protrusion to be inserted into the side surface of the first coating portion opposite to the at least one protrusion disposed on the side surface of the second coating portion.

According to an embodiment of the disclosure, the plurality of coating portions include a first coating portion and a second coating portion. A first hardness of the first coating portion may be smaller than a second hardness of the second coating portion. In the first hard coating layer, the first coating portion may be disposed in the bending area, and the second coating portion may be disposed to cover an upper surface of the base layer and a periphery of the first coating portion in the flat area.

According to an embodiment of the disclosure, in the window, a thickness of the first hard coating layer may decrease toward an edge from a side portion of the bending area not in contact with the flat area.

According to an embodiment of the disclosure, the window may further include a refractive index matching part (e.g., the refractive index matching part 630 of FIG. 7) disposed on an outer surface of the first hard coating layer.

According to an embodiment of the disclosure, the plurality of coating portions may include a first coating portion and a second coating portion. A first hardness of the first coating portion may be less than 30 kpa, and a second hardness of the second coating portion may be larger than or equal to 30 kpa.

According to an embodiment of the disclosure, the window may further include a second hard coating layer (e.g., the second hard coating layer 622 of FIG. 7) disposed on another surface which is a surface opposite to one surface of the base layer and including a plurality of coating portions (e.g., the third coating portion 622a of FIG. 7 or the fourth coating portion 622b of FIG. 7).

According to an embodiment of the disclosure, the second hard coating layer may include a third coating portion and a fourth coating portion. One surface of the third coating portion may contact the other surface of the base layer, and one surface of the fourth coating portion may contact the other surface of the third coating portion.

According to an embodiment of the disclosure, a thickness of the base layer may be 20 *µm* to 40 *µm*.

According to an embodiment of the disclosure, there may be comprised a bendable housing (e.g., the foldable housing 201 of FIG. 2) configured to facilitate bending along a bending axis, and a flexible display (e.g., the flexible or foldable display 250 of FIG. 2) including a display panel, a window disposed on the display panel, and a protective layer disposed on the window, defining a bending area and a flat area remaining flat, and accommodated in the housing. The window may include a base layer, and a first hard coating layer disposed on one surface of the base layer and including a plurality of coating portions having different hardnesses. A thickness of the first hard coating layer disposed on the flat area may be larger than a thickness of the first hard coating layer disposed on the bending area.

According to an embodiment of the disclosure, the plurality of coating portions may include a second coating portion is stacked on an upper surface of a first coating portion. In the first hard coating layer, one surface of the first coating portion may contact one surface of the base layer, and another surface of the first coating portion may contact one surface of a second coating portion.

According to an embodiment of the disclosure, the plurality of coating portions may include a first coating portion disposed in the bending area and a second coating portion disposed in the flat area. A first hardness of the first coating portion may be less than a second hardness of the second coating portion. The first hard coating layer may be disposed so that a portion of a side surface of the first coating portion and a portion of a side surface of the second coating portion contact each other.

According to an embodiment of the disclosure, the plurality of coating portions may include a first coating portion and a second coating portion.

A first hardness of the first coating portion may be smaller than a second hardness of the second coating portion. In the first hard coating layer, the first coating portion may be disposed in the bending area, and the second coating portion may be disposed to cover an upper surface of the base layer and a periphery of the first coating portion in the flat area.

According to an embodiment of the disclosure, the window may further include a refractive index matching part disposed on an outer surface of the first hard coating layer.

## Claims

1. A display device, comprising:
a display panel; and
a window disposed on the display panel, the window including a bending area and a flat area, wherein the window includes:
a base layer; and
a first hard coating layer disposed on one surface of the base layer and including a plurality of coating portions having different hardnesses, and
wherein a thickness of the first hard coating layer disposed on the flat area is larger than a thickness of the first hard coating layer disposed on the bending area.

2. The display device of claim 1,
wherein the plurality of coating portions include a second coating portion is stacked on an upper surface of a first coating portion, and
and wherein in the first hard coating layer, one surface of the first coating portion contacts one surface of the base layer, and another surface of the first coating portion contacts one surface of the second coating portion.

3. The display device of claim 2, wherein a thickness of the first coating portion is relatively thinner in the bending area than in the flat area.

4. The display device of claim 1, wherein the plurality of coating portions include a first coating portion disposed in the bending area and a second coating portion disposed in the flat area,
wherein a first hardness of the first coating portion is less than a second hardness of the second coating portion, and
wherein the first hard coating layer is disposed so that a portion of a side surface of the first coating portion and a portion of a side surface of the second coating portion contact each other.

5. The display device of claim 4, wherein at least one protrusion is disposed on a side surface of the first coating portion contacting the portion of the side surface of the second coating portion, and
wherein at least one groove is disposed to allow the at least one protrusion to be inserted into the side surface of the second coating portion opposite to the at least one protrusion disposed on the side surface of the first coating portion.

6. The display device of claim 4, wherein at least one protrusion is disposed on the side surface of the second coating portion contacting the portion of the side surface of the first coating portion, and
wherein at least one groove is provided to allow the at least one protrusion to be inserted into the side surface of the first coating portion opposite to the at least one protrusion disposed on the side surface of the second coating portion.

7. The display device of claim 1, wherein the plurality of coating portions include a first coating portion and a second coating portion,
wherein a first hardness of the first coating portion is smaller than a second hardness of the second coating portion, and
wherein in the first hard coating layer, the first coating portion is disposed in the bending area, and the second coating portion is disposed to cover an upper surface of the base layer and a periphery of the first coating portion in the flat area.

8. The display device of claim 1, wherein the first hard coating layer has a thickness of 20 um to 30 *µm* in the bending area, and
wherein a thickness of the first hard coating layer decreases toward an edge from a side portion of the bending area not in contact with the flat area.

9. The display device of claim 1, wherein the window further includes a refractive index matching part disposed on an outer surface of the first hard coating layer.

10. The display device of claim 1, wherein the plurality of coating portions include a first coating portion and a second coating portion,
wherein a first hardness of the first coating portion is less than 30 kpa, and
wherein a second hardness of the second coating portion is larger than or equal to 30 kpa.

11. An electronic device, comprising:
a bendable housing configured to facilitate bending along a bending axis; and
a flexible display including a display panel, a window disposed on the display panel, and a protective layer disposed on the window, defining a bending area and a flat area, and accommodated in the housing, wherein the window includes:
a base layer; and
a first hard coating layer disposed on one surface of the base layer and including a plurality of coating portions having different hardnesses, and
wherein a thickness of the first hard coating layer disposed on the flat area is larger than a thickness of the first hard coating layer disposed on the bending area.

12. The electronic device of claim 11, wherein the plurality of coating portions include a second coating portion is stacked on an upper surface of a first coating portion, and
wherein in the first hard coating layer, one surface of the first coating portion contacts one surface of the base layer, and another surface of the first coating portion contacts one surface of the second coating portion.

13. The electronic device of claim 11, wherein the plurality of coating portions include a first coating portion disposed in the bending area and a second coating portion disposed in the flat area,
wherein a first hardness of the first coating portion is less than a second hardness of the second coating portion, and
wherein the first hard coating layer is disposed so that a portion of a side surface of the first coating portion and a portion of a side surface of the second coating portion contact each other.

14. The electronic device of claim 11, wherein the plurality of coating portions include a first coating portion and a second coating portion,
wherein a first hardness of the first coating portion is less than a second hardness of the second coating portion, and
wherein in the first hard coating layer, the first coating portion is disposed in the bending area, and the second coating portion is disposed to cover an upper surface of the base layer and a periphery of the first coating portion in the flat area.

15. The electronic device of claim 11, wherein the window further includes a refractive index matching part disposed on an outer surface of the first hard coating layer.
